# FASCICULE DE BREVET EUROPEEN

(11) **EP 3 198 442 B1**
(45) Date de publication et mention de la délivrance du brevet: **01.11.2023**
(21) Numéro de dépôt: 15766835.1
(22) Date de dépôt: 22.09.2015
(51) Int. Cl.: G06F 8/40

(54) **EXÉCUTION SPÉCULATIVE ET ITÉRATIVE DE GRAPHES DE FLOT DE DONNÉES TEMPORISÉS**
SPEKULATIVE UND ITERATIVE AUSFÜHRUNG VERZÖGERTER DATENFLUSSDIAGRAMME
SPECULATIVE AND ITERATIVE EXECUTION OF DELAYED DATA FLOW GRAPHS

(30) Priorité: 23.09.2014 FR 1458979
(43) Date de publication de la demande: 02.08.2017
(73) Titulaire: Commissariat à l'Énergie Atomique et aux Énergies Alternatives, 75015 Paris (FR)
(72) Inventeur: DUBRULLE, Paul, F-75006 Paris (FR); GOUBIER, Thierry, F-78140 Velizy (FR); LOUISE, Stéphane, F-91400 Orsay (FR)
(74) Mandataire: Atout PI Laplace
(86) Numéro de dépôt international: PCT/EP2015/071692
(87) Numéro de publication internationale: WO 2016/046187

(56) Documents cités:
- EP-A2- 1 672 501
- US-A1- 2005 138 485
- SOLINAS MARCO ET AL: "The TERAFLUX Project: Exploiting the DataFlow Paradigm in Next Generation Teradevices", 2013 EUROMICRO CONFERENCE ON DIGITAL SYSTEM DESIGN, IEEE, 4 septembre 2013 (2013-09-04), pages 272-279, XP032502906, DOI: 10.1109/DSD.2013.39

## Description

### DOMAINE DE L'INVENTION

La présente invention concerne l'exécution de graphes de flots de données avec des calculs distribués. Plus spécifiquement, elle concerne l'exécution de graphes de flot de données lorsqu'une incertitude existe sur l'exécution de certains acteurs du graphe.

### ETAT DE L'ART PRECEDENT

Depuis le début des années 2000, se produit un changement qualitatif dans la progression des architectures de microprocesseurs et la micro-électronique. La loi de Moore qui fournit la feuille de route de l'état de l'art des processus de gravure en micro-électronique continue de se vérifier, puisque le nombre de transistors que l'on peut mettre sur une puce double toujours tous les 20 à 24 mois environ. Mais l'utilisation de transistors supplémentaires est actuellement causée par l'augmentation du nombre de coeurs de calcul, plus que par l'augmentation de la puissance de calcul de chacun des coeurs.

Ainsi, les processeurs de stations de travail disposent déjà d'un nombre important de coeurs par processeur physique : entre 8 et 16 à l'heure actuelle. Si cette tendance se poursuit, dans les années qui viennent le nombre de coeurs par puce dépassera quelques dizaines. De fait, il existe d'ores et déjà quelques processeurs disposant de plusieurs centaines de coeurs par puce. Par exemple, le processeur MPPA-256 de Kalray qui dispose de 256 coeurs de calcul et d'une vingtaine de coeurs pour la gestion du parallélisme et des entrées/sorties.

De tels processeurs sont appelés *manycoeurs*, contraction du mot anglais many, qui signifie beaucoup ou un grand nombre, et du français coeur. La distinction entre multicoeurs et manycoeurs ne se réduit pas uniquement au nombre de coeurs. La différence la plus marquante est plus spécifiquement liée à la façon dont les coeurs de processeurs communiquent. Dans un multicoeur classique, les coeurs disposent d'un bus partagé pour accéder à la mémoire principale. En principe, le bus partagé permet une bonne perception des accès mémoire de la part de tous les coeurs. Il est ainsi relativement aisé de mettre en oeuvre des procédés de cohérence mémoire de manière à s'assurer que tous les coeurs ont la même vision de la mémoire centrale du système. Ces principes sont toujours en vigueur au sein des processeurs couramment accessibles à l'heure actuelle, moyennant une hiérarchie de bus qui apporte quelques nuances au schéma précédent. De façon générale, les processeurs de station de travail à 8 ou 16 coeurs sont désignés par l'acronyme anglais NUMA, pour Non Uniform Memory Accès ou Accès Mémoire Non Uniforme. Pour ces processeurs, l'accès mémoire n'est pas uniforme entre les coeurs de calcul, mais la cohérence des données reste réalisable.

Dans le cadre d'un processeur manycoeurs où le nombre de coeurs de calcul est particulièrement élevé, la possibilité d'établir une cohérence mémoire à grande échelle sur l'ensemble des coeurs est plus problématique. Sans devenir impossible, son coût en termes de synchronisation contrebalance le gain de temps d'exécution généré par le parallélisme, dont il peut remettre en cause l'intérêt. En effet, il est pour ce faire nécessaire de passer par des protocoles distribués mais comportant une partie d'éléments partagés. Il s'agit donc d'une solution globalement peu satisfaisante, d'autant plus que la cohérence mémoire induit une consommation électrique non négligeable. Afin d'adresser ce problème, une partie importante des recherches sur les procédés d'exécution des manycœurs se focalise sur des modèles de calcul qui n'ont pas besoin de cohérence mémoire. Parmi ceux-ci les modèles flots de données sont particulièrement étudiés aujourd'hui.

Les évolutions matérielles précitées induisent une profonde mutation du calcul embarqué, et permettent l'émergence d'applications nouvelles, dont certaines, dans des domaines aussi variés que le calcul haute-performance ou les systèmes temps-réel critiques embarqués, impliquent à la fois de forts besoins en parallélisme et des contraintes temps-réel. A titre d'exemple, J. Mitola. The software radio architecture. Communications Magazine, IEEE, 33(5) :26-38, May 1995 décrit une application de radio logicielle et M. Heskamp, R. Schiphorst, and K. Slump. Cognitive Radio Communications and Networks, chapter Public safety and cognitive radio, pages 467-488. Elsevier, 2009 décrit un système de radio cognitive. Chacune de ces applications demande une forte puissance de calcul couplée à une faible consommation électrique. Toutes deux présentent des contraintes temps-réel et la radio cognitive présente un besoin d'adaptabilité à son environnement. Des contraintes similaires sont rencontrées par les applications de réalité augmentée, par exemple celles décrites par S. Feiner, B. Maclntyre, T. Hollerer, and A. Webster. A touring machine : prototyping 3d mobile augmented reality systems for exploring the urban environment. In Wearable Computers, 1997. Digest of Papers., First International Symposium on, pages 74-81, Oct 1997 et Y. Sato, M. Nakamoto, Y. Tamaki, T. Sasama, I. Sakita, Y. Nakajima, M. Monden, and S. Tamura. Image guidance of breast cancer surgery using 3d ultrasound images and augmented reality visualization, 1998, ainsi que les applications de véhicules autonomies décrites par A. Kushleyev, D. Mellinger, C. Powers, and V. Kumar. Towards a swarm of agile micro quadrotors. Autonomous Robots, 35(4) :287-300, 2013.

La connectivité est un autre aspect important des évolutions technologiques actuelles. De plus en plus d'appareils mobiles intelligents, du capteur intelligent au smartphone, ont la possibilité d'être connectés en permanence les uns aux autres. Chacun de ces appareils mobiles peut être connecté à des serveurs distants ou des systèmes embarqués, comme par exemple le système embarqué d'une voiture. Atzori, A. lera, and G. Morabito. 54(15) :2787-2805, Oct. 2010. *The internet of things : A survey.* Comput. Netw divulgue un essaim de calculateurs mobiles créant une plateforme de calcul globale, hautement parallèle et mutable. Cet article préfigure une capacité de calcul omniprésente et distribuée.

Ainsi, les applications citées précédemment peuvent être vues comme des parties d'un calcul coopératif, dans lequel chaque application peut utiliser les résultats d'autres applications pour améliorer les siens. A. A. Faisul, A. R. Ramli, K. Samsudin, and S. Hashim. Energy management in mobile robotics system based on biologically inspired honeybees behavior. In Computer Applications and Industrial Electronics (ICCAIE), 2011 IEEE International Conférence on, pages 32-35. IEEE, 2011, dans le domaine de la gestion de l'énergie dans la robotique mobile, et Y. Wang, Y. Qi, and Y. Li. Memory-based multiagent coevolution modeling for robust moving object tracking. The Scientific World Journal, 2013, 2013 dans le domaine du suivi de cible robuste, divulgue d'ores et déjà de telles applications, qui requièrent dynamicité, connaissance de l'environnement et adaptation à celui-ci.

Les modèles flots de données et plus particulièrement les réseaux de processus communicants ont été imaginés au départ par Kahn en 1974. Ils rendent les communications entre tâches explicites, ce qui permet une analyse de l'application hors-ligne pour la vérification de propriétés importantes pour une exécution sûre et déterministe.

De nombreux modèles de flots de données utilisent le concept d'acteur introduit par Carl Hewitt; Peter Bishop; Richard Steiger (1973). A Universal Modular Actor Formalism for Artificial Intelligence. IJCAI. Dans le cadre de ce concept et du modèle mathématique associé dit modèle d'acteur, les acteurs sont les seules fonctions primitives nécessaires à la programmation concurrente. Les acteurs communiquent par échange de messages. En réponse à un message, un acteur peut par exemple effectuer un traitement local, créer d'autres acteurs, ou envoyer d'autres messages.

Le principe de base des KPN (acronyme anglais signifiant Kahn Parallel Network, Réseau Parallèle de Kahn en français) est fondé sur un graphe dont les noeuds sont des processus communiquant et dont les liens sont des files (plus communément appelés FIFO, de l'acronyme anglais First In First Out, ou Premier Entré Premier Sorti, en français). Les processus peuvent lire des données sur les canaux d'entrée et écrivent les résultats de leurs calculs sur des canaux de sortie. La granularité des données échangées est dénotée par des jetons (de l'anglais *tokens*) et le nombre de jetons produits et consommés sont des nombre entiers positifs ou nuls.

Les lectures sur les canaux d'entrée sont bloquantes, ce qui signifie que si un processus requiert plus de jetons que présents sur une de ses entrées, il sera bloqué jusqu'à ce que le nombre de jetons requis soit présent sur ladite entrée. Les processus ont le droit d'avoir un état interne et peuvent changer dynamiquement le nombre de jetons attendus en entrée ou produits en sortie.

Le modèle de Kahn est puissant, donne des résultats déterministes (les mêmes entrées produisent les mêmes sorties), local (donc sans nécessité d'avoir des mécanismes de cohérence mémoire), mais il manque de propriétés pour pouvoir l'utiliser en toute confiance dans le cadre de l'informatique embarquée. En particulier, il est impossible de savoir à l'avance si un réseau de processus de Kahn est sans blocages ou s'il va pouvoir s'exécuter en mémoire bornée.

Il existe plusieurs améliorations des KPN pour permettre des vérifications hors-ligne des propriétés essentielles pour le déterminisme et la sûreté de fonctionnement. Parmi ces améliorations, le modèle des CSDF (de l'acronyme anglais Cyclo-Static Data Flow, ou Flot de Données Cyclo-Statiques) est le plus expressif qui conserve la possibilité de faire ces vérifications. K. Denolf, M. Bekooij, J. Cockx, D. Verkest, and H. Corporaal. Exploiting the expressiveness of cyclo-static dataflow to model multimedia implementations. EURASIP Journal on Advances in Signal Processing, 2007(1) :084078, 2007 décrit des analyses possibles de graphes CSDF. De plus, avec les informations sur les temps d'exécution des acteurs et les latences induites par les communications, on peut analyser un graphe CSDF pour déterminer les latences sur un chemin du graphe.

Le brevet FR 28166730 décrit un procédé de sécurisation rendant déterministe l'exécution en temps réel d'applications multitâches. Il décrit notamment les enchaînements d'appels et interruptions système, horloges, et gestion des interruptions au niveau des micronoyaux permettant d'exécuter une tâche en temps-réel de manière déterministe.

Le brevet US 5745687 décrit un système de gestion de flot de données implémenté sur ordinateur. Ce système comprend notamment un service d'organisation, destiné à identifier, parmi un ensemble d'agents, l'agent le plus approprié pour effectuer chacune des tâches du graphe de flots de données.

Le brevet US 6397192 décrit une méthode de synchronisation d'un ou plusieurs graphes de flots de données. Il décrit notamment comment mettre en pause et démarrer/redémarrer l'exécution du graphe de flots de données en fonction de la terminaison ou non de tâches.

Le document Solinas, M., Badia, R. M., Bodin, F., Cohen, A., Evripidou, P., Faraboschi, P., ... & Goodman, D. (2013, September). The TERAFLUX project: Exploiting the dataflow paradigm in next génération teradevices. In Digital System Design (DSD), 2013 Euromicro Conférence on (pp. 272-279). IEEE. divulge des techniques pour améliorer l'exécution de graphes de données, dans un environnement ou la multiplication et la miniaturisation des plateformes matérielles entraîne une augmentation des fautes matérielles. Il divulgue notamment un système dans lequel l'exécution de certaines tâches est dupliquée ; le résultat de deux exécutions est comparé ; s'il diffère, l'une au moins des exécutions est sujette à une faute matérielle : l'exécution de la tâche est relancée sur d'autres coeurs.

Le document US 2005/138485 divulgue un système de compilation de code source, et de code de vérification. Il divulgue notamment un système consistant à exécuter itérativement le code généré afin de détecter une erreur dans une ou plusieurs exécutions.

Le document EP 1 672 501 divulgue un ordinateur capable de détecter les fautes d'exécution, tout en permettant la continuation de l'exécution. Cet ordinateur comprend au moins deux processeurs, associés à un détecteur de fautes d'exécution. Il est capable de séparer les fautes réparables des fautes irréparables. Les fautes, réparables et irréparables d'exécution, sont notées pour chacun des deux processeurs. Lorsque les deux processeurs ne sont plus synchronisés, une comparaison des erreurs permet de favoriser l'exécution d'un des deux processeurs, plutôt que d'arrêter l'exécution des deux.

Cependant, aucune des techniques décrites précédemment ne permet d'assurer l'exécution correcte du graphe de flot de données en cas de défaillance de l'un des agents. Le risque de défaillance devient non négligeable avec l'expansion des calculs distribués et des connections réseaux. A titre d'exemple, un agent d'un graphe de flot de données peut faire appel à une ressource de calcul située sur un réseau externe. Un problème de connexion, par nature non prévisible peut alors menacer le déterminisme de l'exécution, ou du temps d'exécution, de la tâche effectuée par l'agent. De la même manière, lorsqu'un agent exécute une tâche nécessitant des éléments externes, par exemple la réception de signaux GPS, il est très difficile d'assurer le déterminisme d'exécution de la tâche. Dans le cas d'un graphe CSDF, le système de jetons bloque l'exécution du graphe tant que toutes les données attendues ne sont pas parvenues. Le brevet FR 28166730 permet d'obtenir un temps de réponse déterministe pour une tâche temps-réel, mais n'aborde pas la problématique de la défaillance possible de certains acteurs. Le brevet US 5745687 ne traite pas de ce problème et le brevet US 6397192 décrit un mécanisme de synchronisation dans lequel les tâches sont en attente de la fin d'exécution d'autre tâches, mais ne décrit pas de mécanisme permettant de surmonter la défaillance de celles-ci.

De plus, lorsque plusieurs agents sont susceptibles d'effectuer la même tâche avec des qualités de résultats différents, aucune des méthodes susmentionnées ne permet de sélectionner a posteriori celle ayant produit le meilleur résultat. Les tâches pouvant être effectuées par différents agents avec un résultat de qualité variable incluent, par exemple, la géo-localisation par différent moyens, ou l'analyse d'image avec des qualités de résultats différentes. Le brevet US 5745687 permet bien de sélectionner l'agent le plus approprié pour effectuer une tâche, mais il s'agit d'une sélection a priori de l'agent, et non d'une sélection a posteriori d'agents ayant déjà terminé leur tâche et capables de quantifier la qualité de leur résultat.

Enfin, aucune des méthodes ci-dessus ne permet de créer des graphes déterministes garantissant la fourniture d'un résultat à la fois dans un temps borné et de la meilleure qualité possible parmi les résultats fournis par plusieurs agents s'exécutant en parallèle.

### RESUME DE L'INVENTION

A cet effet, l'invention a pour objet un procédé de compilation d'un graphe de flot de données, et un système d'exécution comprenant des moyens adaptés pour exécuter un graphe de flot de données, tel que définis dans les revendication jointes.

Le système selon l'invention permet ainsi d'exécuter un graphe de flot de données en s'assurant d'obtenir un résultat en un temps borné de manière déterministe, tout en se réservant la possibilité d'obtenir un résultat plus performant s'il est disponible.

Un système d'exécution d'un graphe de flot de données selon l'invention est robuste aux événements imprévus, tels que des pannes réseau ou pertes de signaux GPS.

Un système d'exécution d'un graphe de flot de données selon l'invention permet d'exécuter des graphes de données sur des processeurs manycoeurs.

Un système d'exécution d'un graphe de flot de données selon l'invention permet d'obtenir une grande flexibilité dans les règles de sélection du meilleur résultat, et de générer des erreurs en cas de non-obtention d'un résultat de calcul.

Un système d'exécution d'un graphe de flot de données selon l'invention permet de tirer le meilleur parti d'algorithmes de calcul itératifs. Il permet notamment de sélectionner le meilleur résultat fourni par un algorithme de calcul itératif à une date donnée, de comparer ce résultat à celui produit par d'autres algorithmes iératifs ou non itératifs, et de terminer son exécution plus tôt si l'algorithme itératif a terminé son traitement avant la date limite initialement prévue.

Un procédé de compilation d'un graphe de flot de données selon l'invention permet de s'assurer qu'un résultat sera obtenu dans un temps borné de manière déterministe.

### LISTE DES FIGURES

D'autres caractéristiques apparaîtront à la lecture de la description détaillée donnée à titre d'exemple et non limitative qui suit faite au regard de dessins annexés qui représentent:
- les figures 1a, 1b, 1c, trois exemples d'acteurs CSDF selon l'état de l'art;
- les figures 2, un exemple de graphe CSDF selon l'état de l'art ;
- la figure 3, un schéma de principe d'un graphe selon l'invention ;
- les figures 4a, 4b, 4c, 4d, quatre exemples d'acteurs d'un graphe selon l'invention ;
- la figure 5, un exemple de graphe selon l'invention, dans lequel les branches du module comportent deux canaux d'entrée ;
- la figure 6, un exemple de procédé de compilation d'un graphe selon l'invention ;
- la figure 7, un exemple de graphe selon l'invention pour le traitement d'images temps-réel dans le cadre de l'assistance à la conduite d'un véhicule.

### DESCRIPTION DETAILLEE

Dans la suite de la description, la mise en oeuvre de l'invention est illustrée par des exemples relatifs à l'exécution de graphes de flot de données de type CSDF. Il convient cependant de noter que l'invention n'est pas restreinte à des graphes de type CSDF. L'invention est notamment applicable aux types de graphes pour lesquels il est possible de déterminer la latence de chaque branche hors ligne, par exemple à la compilation; pour lesquels il est possible de démontrer l'absence d'interblocages et qui peuvent s'exécuter en mémoire bornée. L'invention ainsi est applicable, par exemple, aux graphes de type « Core Functional Dataflow » (de l'anglais Coeur Fonctionnel de Flots de Données)..

Certains acronymes anglo-saxons couramment utilisés dans le domaine technique de la présente demande pourront être employés au cours de la description et des figures. Ces acronymes sont listés dans le tableau ci-dessous, avec notamment leur expression anglo-saxonne et leur signification.

| ***Acronyme*** | ***Expression*** | ***Signification*** |
|---|---|---|
| ADAS | Advanced Driver Assistance System | Système d'Assistance de Conducteur Avancé. Système de calcul permettant l'aide à la conduite, par exemple avec l'identification automatique de panneaux. |
| CSDF | Cyclo Synchronous Data Flow | Flot de Données Cyclo-Statiques. Evolution du modèle de calcul KPN permettant de vérifier, à la compilation, le respect de contraintes temporelles. |
| FIFO | First In First Out | Premier Entré Premier Sorti. Modèle de calcul informatique appelé « file », dans lequel les tâches sont effectuées dans leur ordre d'arrivée. |
| GPS | Global Positionning Network | Réseau de Positionnement Global. Système de positionnement par satellite. |
| GSM | Global System for Mobile communications | Système Global pour les communications Mobiles. Norme numérique de seconde génération pour la téléphonie mobile. Particulièrement adaptée pour porter la voix et inclut des moyens de localisation entre les antennes et un téléphone mobile. |
| KPN | Kahn Parallel Network | Réseau Parallèle de Kahn. Modèle de calcul distribué. |
| NUMA | Non Uniform Memory Access | Accès Mémoire Non Uniforme. Désigne des processeurs multicoeurs au sein desquels l'accès à la mémoire partagée par les différents coeurs de calcul n'est pas uniforme. |

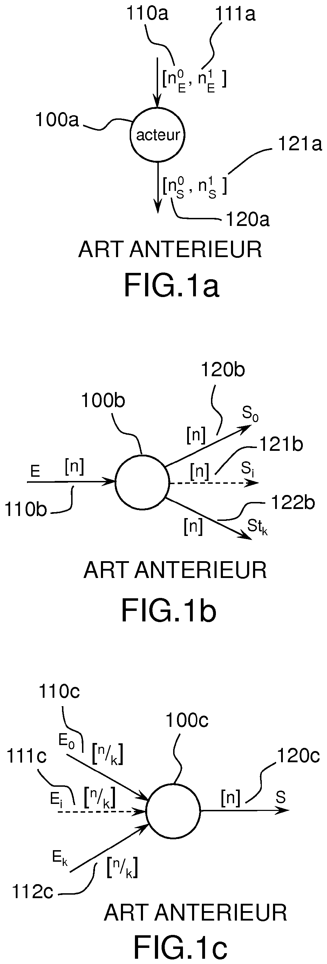

Les figures 1a, 1b, 1c représentent trois exemples d'acteurs CSDF selon l'état de l'art.

La figure 1a représente un exemple d'acteur simple 100a selon l'état de l'art. Cet acteur comporte deux fonctions f₀, f₁. La fonction f₀ consomme n⁰_{E} 110a jetons sur le canal d'entrée et en produit n⁰_{S} 120a sur le canal de sortie. La fonction consomme n¹_{E} 111a jetons sur le canal d'entrée et produit n¹_{S} 121a jetons sur le canal de sortie. Les jetons permettent de synchroniser l'exécution du graphe. En effet, l'exécution des fonctions liées à un acteur, par exemple f₀ et f₁ pour l'acteur 100a démarre lorsque l'ensemble des jetons est reçu sur le canal d'entrée. Inversement, la production de jetons sur le canal de sortie permet de déclencher l'exécution des acteurs suivants. Un tel acteur représente, dans le modèle CSDF, l'élément de base d'un module de calcul ou d'un programme informatique. Ainsi, les fonctions f₀, f₁ de l'acteur peuvent effectuer entre son entrée et sa sortie, un traitement de calcul local, une communication en réseau, ou tout autre opération informatique. D'autres acteurs simples peuvent comporter une, trois, quatre ou une pluralité d'entrées, sorties et fonctions de calcul.

La figure 1b représente un second exemple d'acteur 100b d'un graphe CSDF selon l'état de l'art. Cet acteur, appelé « Duplicate », est utilisé pour dupliquer le contenu d'un canal d'entrée 110b comprenant n éléments en plusieurs canaux de sortie 120b, 121b, 122b comprenant les mêmes n éléments. D'autres exemples d'acteurs « Duplicate » peuvent comprendre au moins deux canaux de sortie. La duplication des données peut s'effectuer selon différentes manières, par exemple par envoi d'adresses mémoires pointant sur un même ensemble de données, par recopie du contenu d'une mémoire dans plusieurs emplacements séparés, ou par envoi de données à différents destinataires sur un réseau. Un acteur similaire, appelé « Split », sépare les n éléments d'un canal d'entrée sur plusieurs canaux de sortie recevant chacun un sous-ensemble des n éléments du canal d'entrée.

La figure 1c représente un troisième exemple d'acteur 100c d'un graphe CSDF selon l'état de l'art. Cet acteur, appelé « Join », est utilisé pour concaténer des ensembles de données issus de trois canaux d'entrée 110c, 111c et 112c en un canal de sortie 120c. D'autres exemples d'acteurs « Join » peuvent comprendre au moins deux canaux d'entrée.

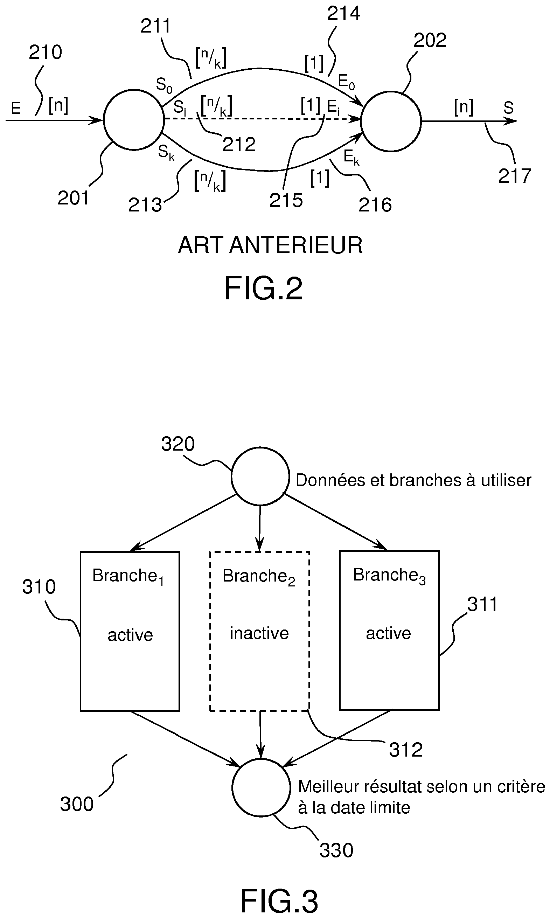

La figure 2 représente un exemple de graphe CSDF selon l'état de l'art. Ce graphe comprend :
- Un premier acteur « Split » 201 ;
- Un second acteur « Join » 202 ;
- Un canal d'entrée 210 ;
- Trois canaux de sorti de l'acteur « Split » 211, 212, 213 ;
- Trois canaux d'entrée de l'acteur « Join » 214, 215, 216
- Un canal de sortie 217 ;

Ce graphe permet de réorganiser des données. A cet effet, l'acteur « Split » 201 sépare les n données du canal d'entrée 210 en trois canaux de sortie 211, 212, 213. L'acteur « Join » 202 réunit les trois canaux de 214, 215, 216 en un canal de sortie 217. Ceci permet un accès des données dans un ordre différent, par exemple une transposition de matrice.

D'une façon générale, les graphes CSDF trouvent bien leur place dans une partie des problèmes temps-réel : les traitements de données en flux, le traitement du signal et de la vidéo. Ils possèdent en effet de nombreuses propriétés désirables pour les applications temps-réelles, telles que le déterminisme d'exécution, et la possibilité de démontrer l'absence de blocage. Il est ainsi possible de trouver des ordonnancements qui permettent aux graphes CSDF d'être compatible avec les contraintes temps-réel. Il est notamment possible de garantir la latence d'une chaîne de calcul CSDF via les acteurs et les files de communication. Cependant, les CSDF ont de la peine à s'adapter à une grande classe des applications temps-réel, car dans les graphes de type CSDF, on fait l'hypothèse que toutes les parties du système sont toujours fonctionnelles. En effet, une défaillance dans un acteur du graphe CSDF bloque l'exécution de tout le graphe.

Or, une composante fondamentale des applications temps-réel, est le cas des applications critiques ou qui comportent au moins une part de criticité. Dans ce cadre là, on ne peut pas faire l'hypothèse qu'un élément du système sera toujours fonctionnel, et en particulier enverra des données au sous-système de calcul. On attend du système temps-réel qu'il fournisse des données aux sorties (par exemple les actionneurs dans les systèmes dits cyber-physiques), même si certaines entrées n'envoient pas de données (pour des problèmes de panne transitoire ou permanente). Les causes de non-fourniture de données aux sorties sont nombreuses. Par exemple, dans le cas d'un calcul, peut se produire une panne. Certains calculs, par exemple dans les domaines de la cryptographie ou du traitement de données multimédia, possèdent un temps d'exécution dépendant de la typologie des données d'entrée, par essence imprédictible. Il est donc très difficile de garantir la fourniture d'un résultat dans un temps donné dans ce cas. Enfin, certains acteurs sont dépendants de conditions externes, par exemple la bonne réception d'un signal GPS ou d'une connexion réseau. Ces acteurs sont alors susceptibles de défaillances de manière imprévisible.

Ceci n'est pas compatible avec les graphes CSDF car un acteur CSDF attend toujours un certain nombre de données sur ses entrées avant de pouvoir s'exécuter. Bien sûr, on peut toujours alimenter le graphe CSDF avec des pseudo-entrées, via des sources virtualisées dont la production est toujours maîtrisée.

D'une façon générale, cela repousse le problème d'un cran, car il faut aussi pouvoir réagir aux pannes internes d'un système de calcul. Pour un système temps-réel, le terme panne (ou faute) est assez large, et couvre en particulier le cas où un élément de calcul est en retard par rapport aux échéances attendues.

Les contraintes des systèmes embarqués imposent aussi de réduire autant que possible la consommation électrique du système lorsque la sécurité n'est pas compromise. Là encore il s'agit d'une contrainte incompatible avec les CSDF en tant que tels, car un graphe ne change pas en cours d'exécution.

Enfin, l'environnement du monde réel étant complexe, il faut parfois faire de l'arbitrage probabiliste entre plusieurs actions, car on ne peut être jamais 100% certain du scénario en cours de déroulement, avec des informations données par les capteurs qui ne permettent pas forcément de connaître les subtilités d'un événement.

Les CSDF sont donc inadaptés en tant que tels pour traiter ces cas, Les KPN pourraient en principe les traiter. L'utilisation de KPN de l'état de l'art ne permet pas d'avoir une assurance sur des propriétés fondamentales de ces systèmes : l'absence de blocage et la possibilité de s'exécuter en mémoire bornée ou avec un ordonnancement qui respecte des contraintes temporelles. L'invention permet de surmonter ces limitations de l'art antérieur.

La figure 3 représente un schéma de principe d'un graphe selon l'invention. Afin de résoudre les inconvénients précités, l'invention concerne un système d'exécution d'un graphe de flot de données 300, le dit graphe de flot de données 300 comprenant :
- au moins deux premiers acteurs 310, 311, comprenant des moyens pour exécuter de manière indépendante le calcul d'un même ensemble de données comprenant au moins une donnée, et produire un descripteur de qualité sur le résultat obtenu, l'exécution du calcul par chacun desdits au moins deux premiers acteurs étant déclenchée par un système de synchronisation ;
- un troisième acteur 320, comprenant des moyens pour déclencher l'exécution du calcul par chacun desdits au moins deux premiers acteurs, et initialiser une horloge configurée pour émettre un signal d'interruption lorsqu'une durée est écoulée ;
- un quatrième acteur 330, comprenant des moyens pour exécuter, au plus tard au signal d'interruption de ladite horloge :
   - la sélection, parmi l'ensemble desdits au moins deux premiers acteurs ayant produit un descripteur de qualité, de celui dont le descripteur présente la valeur la plus favorable ;
   - le transfert de l'ensemble de données calculé par l'acteur sélectionné.

Les au moins deux premiers acteurs 310, 311 comprennent des moyens pour exécuter de manière indépendante le calcul d'une même donnée ou d'un même ensemble de données, et produire un descripteur de qualité sur le résultat obtenu. La donnée ou l'ensemble de données calculées peuvent être de types très divers. A titre d'exemple non limitatif, il peut s'agir de la localisation d'un individu, ou bien du codage d'une image dans une application de compression vidéo. Le descripteur de qualité dépend alors du type d'application choisi. Par exemple, dans le cas d'acteurs destinés à localiser un usager, le descripteur de qualité peut être la précision estimée de la localisation. Dans le cas du codage d'une image dans une application vidéo, il peut s'agir d'une estimation du ratio poids/qualité de la vidéo. Si l'application de codage vidéo alloue un poids fixe et prédéfini à chaque image, il peut s'agir d'un indice de qualité sur l'image.

Dans un mode de réalisation de l'invention, ces au moins deux acteurs comprennent des fonctions de calcul locales utilisant des algorithmes et complexités variables. Dans l'exemple du codage vidéo, il peut s'agir de deux algorithmes de codage différents, chacun d'eux produisant des résultats plus ou moins optimisés suivant le type d'image. Dans un autre mode de réalisation de l'invention, certains acteurs peuvent faire appel à des moyens de calcul distants, ou des données situées sur une machine distante ou bien des données reçues par le biais d'une connexion. Par exemple, dans le cas d'une application de localisation, il est possible d'avoir un premier acteur calculant la position d'un usager grâce à un calcul local par odométrie (estimation d'une nouvelle position par application d'un vecteur déplacement à partir d'une position précédente), un second acteur calculant la même position grâce à la réception de signaux GPS.

Il est bien évidemment possible de disposer de plus de deux acteurs, par exemple avec un acteur supplémentaire 312, et de disposer ainsi de moyens supplémentaires de réaliser le calcul voulu. Ainsi, dans le cas de l'application de localisation, , on peut disposer d'un troisième acteur utilisant une localisation par identification d'une balise de réception de signaux de radiocommunications (cellulaire ou Wifi) à laquelle est rattachée un équipement à localiser comportant un récepteur. Dans un mode de réalisation de l'invention, un seul acteur est utilisé pour chacun des calculs. Dans un second mode de réalisation de l'invention, chacun des calculs est effectué par une branche comportant plusieurs acteurs, et pouvant être compilée comme un graphe selon l'état de l'art, par exemple un graphe CSDF. On appellera dans cette demande « branche de calcul » ou « branche de calcul indépendante » un sous-ensemble du graphe destiné à produire un résultat de calcul et un descripteur de qualité sur ledit résultat, puis envoyer ces deux éléments à un quatrième acteur 330, dont l'exécution est déclenchée par un troisième acteur 320. Chacune de ces branches comporte au moins un acteur.

Le troisième acteur 320 permet de synchroniser l'exécution du graphe, en synchronisant le démarrage des au moins deux premiers acteurs 310, 311, et en initialisant une horloge configurée pour émettre un signal d'interruption lorsqu'une durée est écoulée. Cette durée correspond à la durée maximale d'exécution autorisée pour obtenir un résultat de calcul pour au moins un acteur tout en respectant les contraintes temps-réel. Dans un mode de réalisation de l'invention, cette durée est fixe. Par exemple, dans le cas de la compression vidéo, si la vidéo est encodée à 25 image par seconde, et qu'un graphe 300 est exécuté pour compresser chaque image de la vidéo, alors l'horloge devra être configurée sur une durée fixe de 1/25^{e} de seconde pour tenir les contraintes temps réel. Il est également possible de configurer l'horloge avec une durée variable en fonction de contraintes internes ou externes à l'application.

Le quatrième acteur 330 permet de sélectionner, au plus tard au signal d'interruption de l'horloge initialisée par l'acteur 320, l'acteur parmi les au moins deux premiers acteurs 310, 311 ayant le descripteur de qualité le plus favorable et de transférer les données de sortie de ce capteur comme données de sortie du calcul. Ainsi, le graphe permet de sélectionner, dans un temps déterminé permettant d'assurer les contraintes temps-réel, le meilleur résultat de calcul possible. Le quatrième acteur peut alors transférer les données de sortie les plus favorables, par exemple vers un autre acteur, un autre graphe ou un ensemble du graphe. Par exemple, dans un graphe destiné à la compression vidéo, il peut envoyer l'image compressée la plus favorable vers un acteur dont la fonction est d'enregistrer cette image compressée dans un fichier ; dans le cas d'un graphe pour la localisation, le quatrième acteur peut envoyer la position de l'utilisateur comme donnée de sortie à un acteur dont la fonction est d'afficher la position de l'utilisateur sur un plan.

Dans un ensemble de modes de réalisation de l'invention, au moins un des deux premiers acteurs possède un temps d'exécution déterministe inférieur ou égal à la durée de l'horloge. Ceci permet de s'assurer qu'un résultat sera disponible en un temps borné, tout en se réservant la possibilité d'obtenir un résultat de meilleure qualité.

Dans l'exemple de l'application de compression vidéo, il est possible de configurer un premier acteur pour effectuer une compression de chaque image selon un algorithme possédant un temps de calcul déterministe, par exemple moins de 1/25^{e} de seconde, et un second acteur pour effectuer un algorithme de compression plus performant, mais dont le temps d'exécution varie en fonction des caractéristiques de chaque image. Ainsi, au signal d'interruption de l'horloge, le premier acteur a nécessairement terminé son calcul. Dans le cas d'une image défavorable, le second acteur n'a pas terminé le sien. Le quatrième acteur 330 sélectionne alors le résultat fourni par le premier acteur, qui est le seul disponible. Dans le cas d'une image favorable, le second acteur a terminé son calcul, avec un descripteur de qualité, et donc une qualité d'image à poids égal, supérieure à celle fournie par le premier acteur. Le quatrième acteur sélectionne alors le résultat de calcul fourni par ce second acteur.

Dans l'exemple de l'application de localisation, un premier acteur peut calculer l'emplacement de l'utilisateur par odométrie. Ceci permet, grâce à un calcul local en temps borné, de fournir de manière certaine des coordonnées de localisation au signal d'interruption de l'horloge, même avec une forte marge d'erreur. Un second acteur peut être configuré pour localiser l'utilisateur grâce à des signaux GPS. Ce positionnement est beaucoup plus précis, mais peut être défaillant en cas de mauvaise réception des signaux GPS. Il peut également fournir un résultat plus ou moins précis en fonction du nombre de satellites fournissant un signal. Ainsi, le quatrième acteur est capable de sélectionner, en fonction du contexte d'exécution, la localisation la plus précise, tout en étant certain de disposer d'au moins une mesure de localisation.

Dans un mode de réalisation de l'invention, le troisième acteur peut déclencher, en fonction d'un paramètre externe, l'exécution d'un sous-ensemble seulement des au moins deux premiers acteurs. Par exemple, il est possible de n'exécuter un acteur 312 destiné à calculer la même donnée que les acteurs 310 et 311 que dans certains cas, ou bien de n'exécuter que l'acteur 310 en fonction du contexte d'exécution du graphe. L'exécution ou non de certains acteurs peut par exemple dépendre de la disponibilité de moyens de calcul. Par exemple, si un acteur effectue une partie de ses calculs sur une plate-forme distante, il peut être désactivé si les moyens de connexion vers cette plate-forme sont indisponibles. L'exécution ou non des acteurs peut également dépendre de la disponibilité de moyens de calcul ou de communication. Par exemple, un acteur calculant une localisation à l'aide d'un système de GPS peut être désactivé si les signaux GPS sont indisponibles, ou si un nombre limités de satellites sont disponibles. Dans un autre mode de réalisation de l'invention, les acteurs sont activés ou désactivés en fonction de la puissance de calcul disponible ou souhaitée. Par exemple, dans une application de codage vidéo, il est possible de désactiver un acteur utilisant un algorithme de calcul gourmand en ressources dans un mode « économie d'énergie ».

Un graphe 300 selon l'invention peut être compilé et exécuté en tant que graphe indépendant. Il peut aussi être compilé et exécuté comme un module d'un graphe plus large. On peut alors parler de « module d'un graphe selon l'invention » ou « module selon l'invention ». Un graphe comprenant un module 300 selon l'invention peut comporter d'autres éléments selon l'état de l'art, le reste du graphe pouvant par exemple être un graphe CSDF classique ou contenir d'autres modules 300 selon l'invention. Dans un ensemble de modes de mise en oeuvre de l'invention, un module 300 d'un graphe selon l'invention est appelé « TransactionModule ».

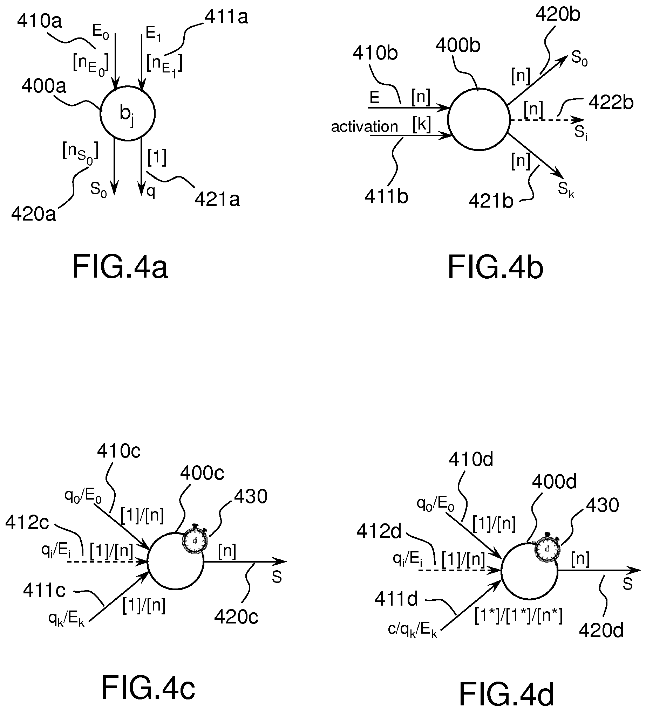

Les figures 4a, 4b, 4c, 4d, représentent quatre exemples d'acteurs d'un graphe selon l'invention. Ces acteurs sont des exemples non limitatifs permettant de mettre en oeuvre l'invention, d'autres acteurs étant également possibles.

La figure 4a représente un exemple d'acteur 400a d'un graphe selon l'invention. Cet acteur 400a peut par exemple former l'une des branches de calcul, ou l'un des au moins deux premiers acteurs comprenant des moyens pour exécuter de manière indépendante le calcul d'une même donnée.

Cet acteur comprend deux canaux d'entrée 410a, 411a. Tous les nombres entiers supérieurs ou égaux à 1 de canaux d'entrée sont bien sûr possibles. Il est par exemple possible d'avoir 1, 2, 3, 4 ou une pluralité de canaux d'entrée. L'acteur 400a peut comprendre des moyens pour effectuer tout type de traitement informatique, par exemple un calcul local, un calcul distribué sur une machine distante, récupérer des données depuis un réseau ou effectuer un calcul nécessitant des données externes obtenues à l'aide d'un capteur.

L'acteur 400a comprend un premier canal de sortie 420a, contenant la donnée calculée. Par exemple, si l'acteur 400a est destiné à calculer la localisation d'un utilisateur, le premier canal de sortie 420a peut contenir des coordonnées de l'utilisateur, suivant différents référentiels. Dans un autre exemple, si l'acteur 400a est destiné à calculer une image vidéo compressée, le premier canal de sortie 420a peut contenir les données compressées, ou une adresse mémoire des données compressées.

L'acteur 400a comprend également un second canal de sortie 421a, contenant un descripteur de qualité sur les données calculées produites sur le canal 420a. Ce descripteur est générique, et de nombreuses représentations de qualité sont possibles. Par exemple, la représentation de qualité peut être un pourcentage. Elle peut également être une donnée liée à l'application considérée, par exemple une incertitude sur la position si l'acteur 400a est destinée à calculer une position, ou un ratio poids/qualité si l'acteur 400a est destiné à encoder une image vidéo.

L'exécution d'un acteur 400a est déclenchée par un mécanisme de synchronisation. Les mécanismes de synchronisation sont décrits de manière générique par les différents modèles de flot de données, notamment par le principe de messages entre les différents acteurs. De nombreux mécanismes de synchronisation et implémentations de ceux-ci sont disponibles. Dans un ensemble de modes de réalisation de l'invention, le mécanisme de synchronisation de l'acteur 400a est un sémaphore. Dans un mode de réalisation de l'invention, ledit sémaphore comporte un jeton. L'exécution de l'acteur 400a démarre alors lorsqu'un jeton est disponible dans le sémaphore, et que l'acteur 400a s'empare de celui-ci. Dans un ensemble de modes de réalisation de l'invention, l'acteur 400a dispose d'un système d'horodatage lui permettant de signifier à d'autres acteurs la fin du transfert de l'ensemble de ses données d'entrée.

La figure 4b représente un exemple d'acteur 400b d'un graphe selon l'invention. Cet acteur 400b peut par exemple former le troisième acteur 320 d'un graphe selon l'invention. Cet acteur, appelé « SelectDuplicate », possède deux entrées 410b et 411b, et une sortie par branche de calcul. Cet acteur est destiné à dupliquer des données d'entrée afin de fournir des paramètres de calcul identiques à chacun des au moins deux premiers acteurs 310, 311 d'une branche de calcul. Il permet également de synchroniser l'exécution de ces au moins deux premiers acteurs 310, 311 et d'initialiser une horloge pour synchroniser la fin de leur exécution.

Cet acteur 400b comprend un premier canal d'entrée 410b. Ce canal d'entrée comporte les données à fournir aux différentes branches de calcul. Par exemple, dans le cas d'une application de codage vidéo, il peut s'agir d'une image à compresser. Il comprend également un canal de sortie par branche, comprenant chacun la donnée dupliquée. Il comprend donc au moins deux canaux de sortie 420b et 421b, ainsi que des canaux de sortie optionnels, par exemple le canal 422b.

L'acteur 400b comprend également une deuxième entrée 411b. Cette entrée contient un paramètre externe indiquant un sous-ensemble des au moins deux premiers acteurs 310, 311 à exécuter. Cette entrée peut par exemple prendre la forme d'un tableau de booléens dont la taille est égale au nombre de canaux de sortie, l'acteur 400b déclenchant uniquement le calcul des acteurs connectés à un canal de sortie dont la valeur est à « vrai » dans le canal d'entrée 411b. Les données du canal d'entrée 411b indiquant les acteurs à exécuter peuvent dépendre de nombreux paramètres ou contextes d'application. Par exemple, elles peuvent être issues d'un fichier de configuration utilisateur indiquant les moyens de calcul à utiliser ou non dans une application. Dans le cas ou certains calculs sont exécutés sur des moyens de calcul distants, le sous-ensemble des acteurs à exécuter décrit dans les données du canal d'entrée 411b peut également comprendre ceux pour lesquels les moyens de calcul adéquats sont disponibles. Ce sous-ensemble peut également dépendre du contexte d'exécution du graphe. Par exemple, dans le cas d'un graphe destiné à la localisation d'un individu, si un acteur calcule la position par odométrie et un second grâce à des signaux GPS, la deuxième entrée 411b peut indiquer de n'exécuter que l'acteur utilisant l'odométrie si les signaux GPS sont indisponibles.

Dans un ensemble de modes de réalisation de l'invention, l'acteur 400b transfère des données identiques à au moins deux premiers acteurs 310, 311 préalablement à l'initialisation de l'horloge. Dans un mode de réalisation de l'invention, l'acteur 400b déclenche l'exécution d'au moins deux premiers acteurs 310, 311 par le don d'un jeton dans un sémaphore. Dans un ensemble de modes de réalisation de l'invention, chacun des au moins deux premiers acteurs 310, 311 produit un horodatage à la fin du transfert des données représentant les paramètres de calcul, et l'acteur 400b déclenche l'initialisation de l'horloge après réception des au moins deux horodatages.

Cet acteur 400b est donné à titre d'exemple uniquement, et d'autres acteurs peuvent occuper la place d'un acteur 320 dans un graphe selon l'invention. Par exemple, dans un graphe selon l'invention avec deux acteurs 310, 311 ne nécessitant pas de données d'entrée, il est possible d'avoir un acteur 320 uniquement destiné à initialiser le calcul des acteurs 310, 311 et une horloge pour la synchronisation de la fin de celui-ci. Dans le cas où l'ensemble des au moins deux premiers acteurs 310, 311 est utilisé en permanence, le second canal d'entrée 411b n'est pas nécessaire. L'acteur est alors un « Duplicate » selon l'état de l'art représenté en figure 1b qui initialise une horloge à la fin du transfert des données. De même, un acteur 320 peut comprendre autant de canaux de sortie qu'il y a de branches de calcul.

La figure 4c représente un exemple d'acteur 400c d'un graphe selon l'invention. Cet acteur, également appelé « Transaction », est destiné à sélectionner, parmi un ensemble de canaux d'entrée, celui dont le descripteur de qualité est le plus favorable, et à transférer le résultat associé à un canal de sortie. Il peut ainsi remplir le rôle d'un quatrième acteur 330 d'un graphe selon l'invention.

A cet effet, l'acteur 400c comporte au moins deux canaux d'entrée 410c, 411c. Il peut comprendre autant de canaux d'entrée qu'il y a de branches de calcul dans le graphe. Par exemple, il peut comprendre un troisième canal d'entrée 412c. Chacun des canaux d'entrée comporte un ensemble de données d'entrée et un descripteur de qualité sur celles-ci. Ces données d'entrée et descripteur de qualité correspondent à la sortie des au moins deux premiers acteurs 310, 311 ou branches de calcul.

Au plus tard au signal d'interruption de l'horloge 430 initialisée par un acteur 320, l'acteur 400c sélectionne le canal parmi les au moins deux canaux d'entrée 410c, 411c présentant le descripteur de qualité le plus favorable et transfère ses données de sortie vers son canal de sortie 420c.

En fonction de l'exécution du graphe, toutes les branches de calcul n'ont pas nécessairement terminé leur calcul au signal d'interruption de l'horloge. Dans ce cas, une branche de calcul n'ayant pas terminé son calcul ne produit ni données de sortie ni descripteur de qualité. Dans un ensemble de modes de réalisation de l'invention, le quatrième acteur 330, par exemple un acteur « Transaction » 430, comprend des moyens pour générer une erreur lorsque, au signal d'interruption de l'horloge, le nombre parmi les au moins deux premiers acteurs ayant produit un descripteur de qualité est inférieur à un seuil prédéfini. Dans un mode de réalisation de l'invention, ce seuil dépend de caractéristiques opérationnelles. Par exemple, dans une application de géo-localisation, une mesure peut être considérée comme fiable si un choix entre le résultat d'au moins deux branches est effectué. Dans ce cas, l'acteur 400c comprend des moyens pour générer une erreur lorsque, au signal d'interruption de l'horloge, moins de deux canaux d'entrée présentent un descripteur de qualité. Dans un autre mode de réalisation de l'invention, les contraintes temps-réel impliquent de disposer d'un résultat sur au moins une branche de calcul au signal d'interruption de l'horloge. C'est par exemple le cas dans un graphe destiné à encoder une vidéo en temps réel avec par exemple 25 images à encoder par seconde. Dans ce cas, un acteur 400c peut comprendre des moyens pour générer une erreur si aucun résultat n'est disponible au signal d'interruption de l'horloge.

Dans un ensemble de modes de réalisation de l'invention, la sélection par un quatrième acteur 330, par exemple un acteur « Transaction » 400c, de l'acteur ou de la branche dont le critère de qualité présente la valeur la plus favorable est effectuée au signal d'interruption de l'horloge. Dans un autre ensemble de modes de réalisation de l'invention, cette sélection peut s'opérer avant le signal d'interruption de l'horloge. Par exemple, cette sélection peut s'opérer lorsqu'au moins un nombre prédéfini parmi les au moins deux premiers acteurs ont produit un descripteur de qualité. Dans un mode de réalisation de l'invention, la sélection peut s'opérer si l'ensemble des canaux d'entrée 410c, 411c, 412c... d'un acteur « Transaction » 400c ont produit un descripteur de qualité, et donc si tous les au moins deux premiers acteurs 310, 311... ont terminé leur calcul. Dans un autre mode de réalisation de l'invention, un graphe peut être configuré pour sélectionner le résultat le plus favorable si au moins un certain nombre de branches ont terminé leur calcul.

Ceci permet une grande flexibilité dans le choix du meilleur résultat de calcul. Par exemple, dans le cas d'une application de géo-localisation comprenant trois acteurs pour le calcul de la position d'un utilisateur (par exemple, un par odométrie, un utilisant des signaux GPS et un utilisant des signaux GSM), il est possible de définir les règles ci-après pour la sélection de la position la plus précise. Si avant le signal d'interruption de l'horloge, au moins deux acteurs ont terminé leur calcul et fourni une localisation et une précision, la localisation la plus précise parmi les deux est sélectionnée. A défaut, au signal d'interruption de l'horloge, si un des acteurs a terminé son calcul, la position retournée est sélectionnée. La compilation d'un graphe selon l'invention permet de s'assurer qu'un résultat de calcul est retourné en temps voulu. Toutefois, si en cas d'anomalie dans l'exécution du graphe (par exemple, panne ou erreur matérielle par essence imprévisible) ce n'était pas le cas, et qu'aucun acteur n'a terminé son calcul de géo-localisation, une erreur est générée.

L'acteur « Transaction » 400c est donné à titre d'exemple uniquement d'un quatrième acteur 330 d'un graphe selon l'invention.

La figure 4d représente un exemple d'acteur 400d d'un graphe selon l'invention. Cet acteur, appelé, « IterativeTransaction », est une spécialisation d'un acteur « Transaction » 400c.

Cet acteur 400d est en grande partie semblable à l'acteur 400c. Il comprend notamment autant de canaux d'entrée qu'il y a de branches de calcul, avec au moins deux canaux d'entrée 410d et 411d, et par exemple un troisième canal d'entrée 412d. Il comprend également un canal de sortie 420d et sélectionne le résultat le plus favorable parmi ses canaux d'entrée ayant produit un descripteur de qualité au plus tard au signal d'interruption de l'horloge 430.

L'acteur 400d se distingue de l'acteur 400c en ce qu'au moins un parmi les au moins deux premiers acteurs 310, 311 liée à canal d'entrée, par exemple le canal 411d, produit une mise à jour de sa donnée ou de son ensemble de données, ainsi que de son descripteur de qualité associé. Dans un ensemble de modes de mise en oeuvre de l'invention, ledit acteur produit des résultats et descripteurs de qualité successifs, et donne un jeton à un sémaphore lorsque son exécution est terminée.

Ce fonctionnement est particulièrement adapté pour des algorithmes itératifs améliorant progressivement leur résultat par itérations successives. Dans un mode de réalisation de l'invention, au signal d'interruption de l'horloge, l'acteur « IterativeTransaction » 400d considère les derniers résultats et descripteur de qualité fournis par ledit acteur pour sélectionner le meilleur résultat parmi ses canaux d'entrée. Dans un mode de réalisation de l'invention, au signal d'interruption de l'horloge, l'acteur « IterativeTransaction » 400d vérifie la présence d'un résultat de calcul et d'un descripteur de qualité sur un canal d'entrée associé à un acteur produisant des résultats de manière itérative, par exemple le canal 411d, pour vérifier le nombre de résultats disponibles. Dans un mode de réalisation de l'invention, l'acteur « IterativeTransaction » 411d déclenche la sélection du résultat le plus favorable avant le signal d'interruption de l'horloge si le nombre de jetons reçus dans un sémaphore depuis les canaux d'entrée est au moins égal à un seuil prédéfini.

Ces propriétés permettent à un graphe selon l'invention de tirer le meilleur parti des algorithmes itératifs. Notamment, cela permet, à une date prédéfinie, de récupérer le dernier résultat produit par l'algorithme itératif, qui est donc le meilleur disponible à cette date. Un graphe selon l'invention est également capable de comparer des résultats produits par des algorithmes itératifs et non itératifs. Enfin, un graphe selon l'invention est capable de terminer le traitement des données plus tôt si l'algorithme itératif a terminé son traitement, ce qui est par nature imprévisible.

L'acteur 400d est donné à titre d'exemple uniquement d'un acteur 330 destiné à sélectionner le résultat de calcul le plus favorable au plus tard au signal d'interruption d'une horloge 430 tout en prenant en entrée des données issues d'acteurs produisant des mises à jour de leurs données de sortie et descripteurs de qualité.

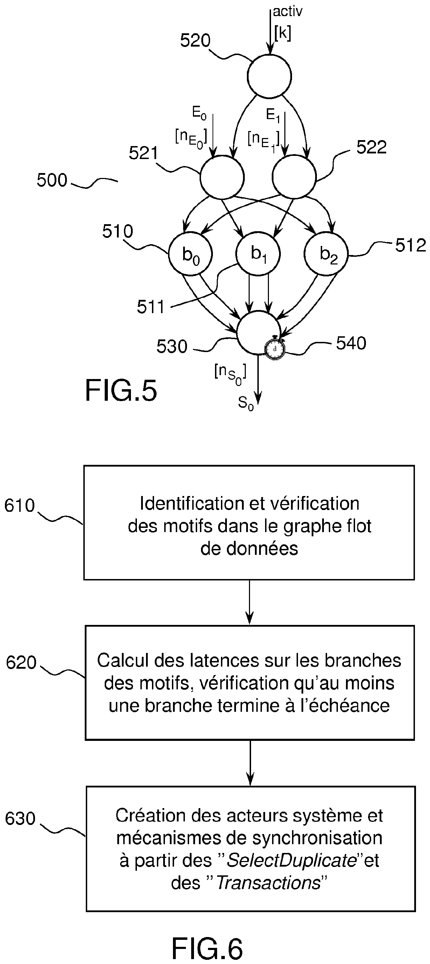

La figure 5 représente un exemple de graphe selon l'invention, dans lequel les branches du module comportent deux canaux d'entrée.

Ce graphe, donné à titre d'exemple uniquement, comprend trois branches pour le calcul d'une donnée de sortie, chacune étant constituée d'un acteur 510, 511, 512. Chaque acteur comprend deux canaux d'entrée et deux canaux de sortie et est semblable à l'acteur 400a. Il comprend également un acteur 520 comprenant des moyens pour déclencher l'exécution du calcul d'un sous-ensemble des acteurs 510, 511 et 512 suivant une liste de branches à exécuter obtenues sur son canal d'entrée. Il comprend également des moyens pour initialiser une horloge 540 pour émettre un signal d'interruption lorsqu'une durée est écoulée.

L'acteur 520 fournit la liste des branches à exécuter à deux acteurs 521, 522 de type « SelectDuplicate » 400b, chacun de ces acteurs dupliquant une donnée d'entrée pour chacun des acteurs 510, 511, 512 à exécuter. Ainsi, les acteurs 510, 511, 512 à exécuter disposent de deux jeux de données d'entrée identiques. Dans un mode de réalisation de l'invention, chacun des acteurs 521, 522 donne un jeton à un sémaphore lié à chacun des acteurs 510, 511, 512, et l'exécution de chacun des acteurs 510, 511, 512 démarre lorsque son sémaphore a reçu autant de jetons qu'il possède de canaux d'entrée. Chacun des acteurs 510, 511, 512 produit un résultat de calcul et un descripteur de qualité en sortie.

Dans ce graphe, chaque branche 510, 511 et 512 est indépendante, et peut consister en un seul acteur ou en un graphe CSDF classique. Il est ainsi possible de déterminer, pour chacun de ces graphes, un temps d'exécution, et donc de prévoir, par exemple à la compilation, un temps d'exécution pour certaines branches. Pour des branches dont le temps d'exécution dépend de la typologie des données d'entrée, il peut être possible de prévoir un temps d'exécution minimal et/ou maximal. Enfin, il est possible d'identifier les branches pour lesquelles aucune panne n'est censée survenir (par exemple, des branches comportant uniquement des calculs locaux), et les branches pour lesquelles un risque de défaillance existe (par exemple, si la capacité de calcul dépend de la réception de signaux ou si une partie du calcul est effectuée sur une plate-forme distante).

Enfin, un dernier acteur 530 de type « Transaction » 400c sélectionne, au plus tard au signal d'interruption de l'horloge 540, l'acteur parmi les acteurs 510, 511, 512 ayant produit le descripteur de qualité le plus favorable et transfère son résultat vers le canal de sortie du graphe.

La figure 6 représente un exemple de procédé de compilation d'un graphe selon l'invention.

Ce procédé, donné à titre d'exemple illustratif uniquement, a pour but d'analyser un graphe, tel que par exemple le graphe 500, et de le convertir en acteurs systèmes afin de pouvoir l'exécuter, tout en validant certaines contraintes d'exécution temps-réel.

Un exemple de procédé de compilation d'un graphe selon l'invention peut comprendre plus spécifiquement :
- Lorsque les modules d'un graphe selon l'invention ne sont pas créés automatiquement, une étape 610 d'identification et vérification des motifs dans un graphe de flot de données ;
- Une étape 620 de calcul des latences sur les branches des motifs, et de vérification qu'au moins une branche termine à l'échéance ;
- Une étape 630 de création des acteurs système et mécanismes de synchronisation à partir des « SelectDuplicate » et « Transactions ».

L'identification et la création de graphes selon l'invention peuvent être effectuées directement par une interface de programmation. Il est également possible, à partir d'un graphe, par exemple le graphe 500, d'identifier, à l'étape 610, les modules 300 du graphe selon l'invention, puis de les compiler spécifiquement. Dans un mode de mise en oeuvre de l'invention appliqué aux graphes CSDF, l'étape 610 peut consister en la détection des « TransactionModule » 300 au sein d'un graphe CSDF. Dans le cas où une interface de programmation permet d'insérer directement des modules selon l'invention, un procédé de compilation permet de passer directement à l'étape 620.

Un procédé de compilation d'un graphe selon l'invention comprend notamment une étape de création d'au moins deux premiers groupes d'instructions d'un code informatique correspondant aux au moins deux premiers acteurs 310, 311 pour exécuter de manière indépendante le calcul d'une même donnée ou d'un même ensemble de données, et pour produire un descripteur de qualité sur le résultat obtenu, l'exécution du calcul par les au moins deux premiers groupes d'instructions d'un code informatique étant déclenchée par un système de synchronisation. Ces au moins deux premiers acteurs 310, 311 peuvent constituer en eux-mêmes une branche de calcul indépendante, ou faire partie d'une branche de calcul indépendante pour le calcul d'une donnée ou d'un ensemble de données. Dans ce dernier cas la branche indépendante peut être compilée suivant une méthode de l'état de l'art, par exemple comme une branche d'un graphe CSDF.

L'étape 620 consiste à identifier, dans le cadre de l'exécution normale du graphe, la latence de chaque acteur ou branche indépendante. Cette étape permet de s'assurer que le graphe est capable de produire un résultat de calcul en temps-réel. Elle peut par exemple consister en une étape de vérification qu'au moins un parmi les au moins deux premiers groupes d'instructions d'un code informatique est capable d'exécuter son calcul de manière déterministe dans une durée prédéfinie. Le calcul de latence peut également s'appliquer à une branche indépendante, par exemple compilée comme un graphe CSDF classique. Cette étape peut s'exécuter avant ou après la création des au moins deux premiers acteurs 310, 311.

Dans un mode de réalisation de l'invention, l'algorithme de compilation renvoie une erreur de compilation lorsqu'aucun des au moins deux groupes d'instructions d'un code informatique ne remplit ce critère.

L'étape 630, pouvant par exemple être exécutée une fois que l'étape 620 est validée, comprend la création d'acteurs système et mécanismes de synchronisation.

Elle peut notamment comprendre une étape de création d'un troisième groupe d'instructions d'un code informatique correspondant à un troisième acteur 320 pour déclencher l'exécution du calcul par chacun desdits au moins deux premiers groupes d'instructions d'un code informatique, et initialiser une horloge configurée pour émettre un signal d'interruption lorsque ladite durée prédéfinie est terminée.

Elle peut également comprendre une étape de création d'un quatrième groupe d'instructions d'un code informatique correspondant à un quatrième acteur 330 pour exécuter, au plus tard au signal d'interruption de l'horloge : la sélection, parmi l'ensemble des au moins deux premiers groupes d'instructions d'un code informatique ayant produit un descripteur de qualité, de celui dont le descripteur présente la valeur la plus favorable ; le transfert de la donnée ou de l'ensemble de données calculé par le groupe d'instructions d'un code informatique sélectionné.

Les paragraphes ci-dessous décrivent de manière plus détaillée, à titre d'exemple uniquement, un ensemble d'objets système et un service support système permettant de compiler un graphe selon l'invention, ainsi qu'un algorithme de compilation écrit en pseudo-code.

Un système pour l'exécution d'un graphe compilé par un procédé selon l'invention peut comprendre un service système de support adapté. Ce service système de support peut notamment comprendre des moyens pour le transfert de données. De nombreuses implémentations sont possibles pour le transfert de données. Par exemple, il peut s'agir d'une copie mémoire, de l'envoi d'une adresse mémoire, de protocoles complexes sur un bus dédié ou de protocoles réseau. Il est également possible de disposer pour un même graphe de plusieurs implémentations du transfert de données en fonction des acteurs impliqués.

Le service système de support peut également comprendre des moyens pour la gestion du temps et des interruptions. Par exemple, ces moyens peuvent comprendre la création d'une horloge ou la configuration d'une interruption. Lorsque le graphe selon l'invention comprend plusieurs entrées, il est possible d'incrémenter un compteur à chaque fois qu'une entrée est prise en compte, et de configurer l'horloge ou l'interruption dès que le compteur atteint le nombre d'entrées pour produire un signal d'interruption à l'échéance d'une durée prédéfinie. Si chaque branche signifie la fin de son calcul à l'aide d'un sémaphore, le service système de support peut déclencher la sélection du meilleur résultat au signal d'interruption en remplissant l'ensemble des sémaphores liés aux différentes branches.

Le service système support peut également réinitialiser l'ensemble des acteurs du module à la fin de la transaction. Il peut notamment, pour ce faire, interrompre tous les acteurs du module, les réinitialiser ainsi que les sémaphores et les paramètres du service système. Ainsi, une nouvelle transaction peut avoir lieu avec de nouveaux paramètres.

Un système pour l'exécution d'un graphe selon l'invention peut également comprendre des acteurs systèmes spécifiques, qui sont créés lors de la compilation d'un module.

Dans un mode de réalisation de l'invention, la compilation d'un acteur « SelectDuplicate » 400b produit les objets système suivants:
- un sémaphore par branche à capacité de un jeton chacun, initialement vide;
- un « ApplnputTrigger »: possède les entrées d'activation et de données, et déclenche le transfert de données vers les « BranchlnputTriggers » liés aux acteurs actifs, et met à jour l'horodatage une fois le transfert des données terminées;
- un « BranchlnputTrigger » par branche: en attente du jeton fourni par l' « ApplnputTrigger », il déclenche la mise à disposition des données aux acteurs de la branche concernée et l'activation d'une branche.

Dans un mode de réalisation de l'invention, la compilation d'un acteur « Transaction » 400c ou produit les objets système suivants:
- Un « BranchOutputTrigger » par branche: ne possède que le couple d'entrées pour les données et le descripteur de qualité. Il est destiné à déclencher le transfert des données vers l'« AppOutputTrigger » et à placer un jeton dans un sémaphore pour signifier la fin de l'exécution de sa branche;
- Un sémaphore dont le nombre d'entrées correspond au nombre de branches nécessaires pour déclencher la sélection du meilleur résultat ;
- Un « AppOutputTrigger » : l' « AppOutputTrigger » est en attente d'un nombre de jetons au plus égal au nombre de branches du module sur le sémaphore. Ce sémaphore peut être rempli soit à la fin de l'exécution des branches, soit au signal d'interruption de l'horloge. Lorsque le sémaphore est rempli, l' « AppOutputTrigger » sélectionne le résultat le plus favorable à partir des descripteurs de qualité et déclenche le transfert des données de sortie.

Dans un mode de réalisation de l'invention, la compilation d'un acteur « IterativeTranscation » 400d, est semblable à celle d'un acteur « Transaction » 400c, à la différence près que le « BranchOutputTrigger » est remplacé par un « IterativeBranchOutputTrigger » pour chaque branche itérative. L'« IterativeBranchOutputTriger » possède en plus du « BranchOutputTrigger » une entrée de validation pour les résultats itératifs.

Les acteurs système ci-dessus sont donnés à titre d'exemple uniquement. D'autres acteurs systèmes sont possibles pour mettre en oeuvre un graphe selon l'invention sur différentes plateformes.

Les algorithmes présentés en annexe, donnés à titre d'exemple uniquement, permettent de détecter un graphe selon l'invention, d'identifier les branches indépendantes, de vérifier qu'au moins une branche s'exécute en un temps borné et de créer des objets système permettant d'exécuter le graphe. Dans le cadre de ces algorithmes, un graphe selon l'invention est appelé un « TransactionModule ». Les algorithmes ci-dessous sont écrits dans un pseudo code de langue anglaise dont les mots-clés ont la signification suivante :
- Input (de l'anglais entrée) : paramètre d'entrée de l'algorithme
- Output (de l'anglais sortie) : paramètre de sortie de l'algorithme
- For ... do ... end (de l'anglais pour les...faire...fin) : pour tous les éléments cités entre le mot-clé « for » et le mot-clé « do », l'ensemble de la boucle entre le mot-clé « do » et le premier mot-clé « end » possédant le même niveau d'indentation que le mot-clé « for » est exécutée ;
- If ... then ...end (de l'anglais si...alors...fin) : si la condition située entre « if » et « then » est vérifiée, l'ensemble de la boucle indentée à partir de la ligne du dessous est exécutée, jusqu'au premier mot-clé « end » possédant une indentation identique au mot-clé « if » ;
- While...do...end (de l'anglais tant que...faire...fin) : tant que la condition entre le mot-clé « while » et le mot-clé « do » est vérifiée, la boucle entre le mot-clé « do » et le premier mot-clé « end » ayant le même niveau d'indentation que le premier mot-clé « while » est effectuée ;
- If ... then ... else ... end (de l'anglais si...alors...sinon...fin) : si la condition entre le mot-clé « if » et le mot-clé « then » est vérifiée, alors l'ensemble de de la boucle entre le mot-clé « then » et le premier mot-clé « else » possédant le même niveau d'indentation que le mot-clé « if » est exécutée. Sinon, l'ensemble de la boucle entre les premiers mot-clés « else » et « end » possédant le même niveau d'indentation que le mot-clé « if » est exécutée ;
- If ... then ... else if ... then ... end (de l'anglais si...alors...sinon si...alors...fin) : si la condition entre le mot-clé « if » et le mot-clé « then » est vérifiée, alors l'ensemble de de la boucle entre le mot-clé « then » et le premier mot-clé « else » possédant le même niveau d'indentation que le mot-clé « if » est exécutée. Sinon, si la condition entre le mot-clé « else if » et le mot-clé « then » est vérifiée, l'ensemble de la boucle entre le second mot-clé « then » et le premier mot-clés « end » possédant le même niveau d'indentation que le mot-clé « if » est exécutée.
- Forall the ... do ... end (de l'anglais pour les tous les...faire...fin) : pour tous les éléments cités entre le mot-clé « forall the » et le mot-clé « do », l'ensemble de la boucle entre le mot-clé « do » et le premier mot-clé « end » possédant le même niveau d'indentation que le mot-clé « for » est exécutée ;
L'algorithme 1, ainsi que les autres exemples d'algorithmes présentés dans la présente demande comprend également des symboles mathématiques ou informatiques conservant leur signification classique. Par exemple :
- ∈ signifie "Appartenant à" ou "appartient à"
- **∉** signifie "n'appartenant pas à" ou "n'appartient pas à"
- = signifie "est égal à"
- ≠ signifie "est différend de"
- ← signifie un assignation de la valeur de l'opérande de droite à l'opérande de gauche
- U représente l'union de l'ensemble situé dans l'opérande de droite et l'ensemble situé dans l'opérande de gauche
- | | représente le cardinal (taille en nombre d'éléments) de l'ensemble situé entre les deux barres verticales
Selon une norme répandue dans un grand nombre de programmes informatiques, les lignes dont les deux premiers caractères sont « // » sont des lignes de commentaires. Ces lignes sont destinées uniquement à faciliter la compréhension du code par un programmeur, et ne font pas partie de l'algorithme en tant que tel.

L'algorithme 1 permet, à partir d'un graphe de flot de données, d'identifier l'ensemble des graphes selon l'invention, appelés ici TransactionModule. L'algorithme 2, donné en annexe permet d'identifier et vérifier les entrées de ce graphe.

L'algorithme 3, en annexe, comprend l'identification et la vérification des sorties du graphe, ainsi que l'identification des acteurs sur un chemin entre une entrée et une sortie.

Un graphe selon l'invention peut constituer une partie d'un graphe CSDF plus large. Cependant, en dehors de ces entrées et sorties principales il ne doit de préférence pas contenir de connexion extérieure vers un des acteurs du graphe. l'algorithme 4, dont un exemple de code est fourni en annexe, permet de vérifier cette propriété.

En particulier cet algorithme comprend préalablement à l'étape de création d'au moins deux groupes d'instructions d'un code informatique correspondant à au moins deux premiers acteurs : une étape de vérification de l'existence des au moins deux premiers acteurs, du troisième acteur et du quatrième acteur ; une étape de vérification que les canaux d'entrée des au moins deux premiers acteurs sont connectés au troisième acteur ; une étape de vérification que les canaux de sortie des au moins deux premiers acteurs sont connectés au quatrième acteur, une étape de vérification que les canaux de sortie du troisième acteur sont connectés aux au moins deux premiers acteurs ; une étape de vérification que les canaux d'entrée du quatrième acteur sont connectés aux au moins deux premiers acteurs.

L'algorithme 5, dont un exemple de code est fourni en annexe, permet de construire les acteurs pour chacune des branches et de vérifier que les branches sont bien indépendantes.

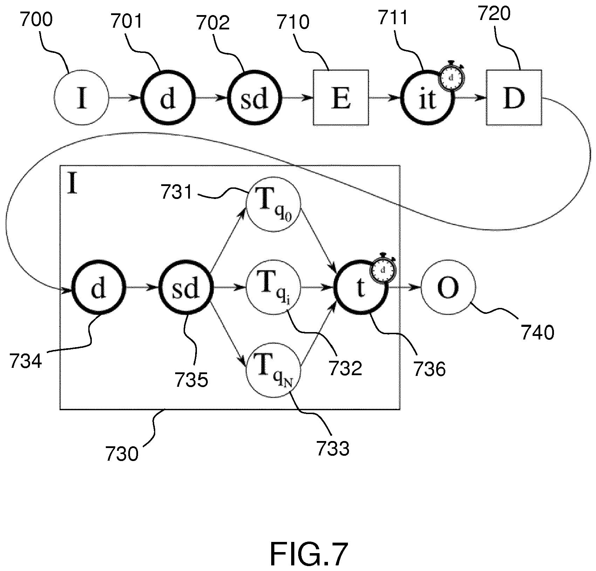

La figure 7 représente un exemple de graphe selon l'invention pour le traitement d'images temps-réel dans le cadre de l'assistance à la conduite d'un véhicule.

Cette application, donnée à titre d'exemple uniquement, effectue du traitement d'images avec des contraintes temps-réel, dans le contexte d'un système avancé d'aide à la conduite d'un véhicule (ADAS ou Advanced Driver Assistance System) pour l'identification des panneaux de signalisation (indications, limites de vitesses, interdictions). L'application lit des images de taille maximum WxH, où W (de l'anglais Width) représente la largeur de l'image et H sa hauteur, depuis une source externe (capteur, caméra vidéo) à une fréquence de 1/x, où x représente la fréquence de lecture des images. Chaque image est traitée par une suite d'algorithmes de traitement du signal. Cette application doit produire une pluralité descripteurs de panneaux de signalisation identifiés en une durée limite à partir de l'acquisition de l'image.

Le graphe 7 pour le traitement d'images est exécuté pour chaque nouvelle image à analyser. Dans le cas où 25 images sont produites par seconde, il doit s'exécuter en 1/25^{e} de seconde. On notera dans l'exemple t le temps maximal autorisé pour l'exécution du graphe. Le graphe 7 reçoit, pour chaque image, une donnée d'entrée « I » 700. Cette donnée peut par exemple comprendre les données brutes d'une image capturée par la caméra.

Un premier acteur algorithmique « E » 710 consiste à améliorer l'image d'entrée. Dans le cadre du graphe, cet acteur est entouré de trois acteurs « Duplicate » 701, « SelectDuplicate » 702 et « IterativeTransaction » 711. L'acteur « IterativeTransaction » 711 est lié à une horloge s'assurant que l'étape d'amélioration de l'image s'exécute au maximum dans une durée a. Un second acteur algorithmique « D » 720 permet d'identifier les zones d'intérêt, en l'occurrence les panneaux de signalisation. Ces acteurs peuvent être compilés et exécutés comme un graphe CSDF selon l'état de l'art.

Enfin, un module « I » 730 du graphe selon l'invention est chargé d'analyser les zone d'intérêt afin d'identifier et extraire l'information des panneaux de signalisation. Les algorithmes d'extraction d'information sont complexes à mettre en oeuvre, et leur temps d'exécution varie en fonction d'un paramètre de qualité. Afin d'assurer l'obtention d'au moins un résultat, et d'obtenir le meilleur résultat possible selon plusieurs paramètres de qualité en un temps déterministe, un graphe selon l'invention est mis en oeuvre. La durée maximale autorisée pour l'analyse des zones d'intérêt sera notée b.

Ce graphe comprend une pluralité d'acteurs « Tq₀ » 731, « Tq₁ » 732 ... « Tq_{N} » 733 permettant d'analyser les panneaux selon différents paramètres de qualité. Ces acteurs s'exécutent en parallèle et permettent d'obtenir une analyse plus ou moins fiable, ainsi qu'un descripteur de qualité associé. Afin de garantir la fourniture d'un résultat en temps voulu, au moins un parmi la pluralité d'acteurs, par exemple l'acteur « Tq₀ » 731 possède une latence déterministe et bornée inférieure à la durée b. Le module du graphe 730 comprend également un acteur « Duplicate » 734 et un acteur « SelectDuplicate » 735 pour fournir les zones d'intérêts et paramètres d'entrée à la pluralité d'acteurs 731, 732, ..., 733, ainsi que d'initialiser une horloge devant produire un signal d'interruption au bout de la durée b. Enfin, un acteur « Transaction » 736 sélectionne, au plus tard au signal d'interruption de l'horloge, l'acteur parmi la pluralité d'acteurs 731, 732, ..., 733 ayant terminé son traitement et produit le descripteur de qualité le plus favorable, et transfère ses résultats de calcul à la sortie « O » 740.

Un graphe selon l'invention permet donc bien, dans ce cas, de tenir des contraintes temps-réel et de fournir un résultat de calcul au moment voulu. Il permet également de sélectionner, à une date limite, la boucle de traitement ayant terminé son calcul et fourni le résultat de la meilleure qualité disponible. Il permet donc de garantir la disponibilité d'un résultat de calcul en temps réel, tout en se réservant la possibilité d'avoir le résultat de calcul présentant la meilleure qualité possible dans le temps imparti.

Les exemples donnés ci-dessus sont donnés à titre indicatif uniquement, et ne limitent en rien la portée de l'invention, définie par les revendications ci-dessous.

### ANNEXES

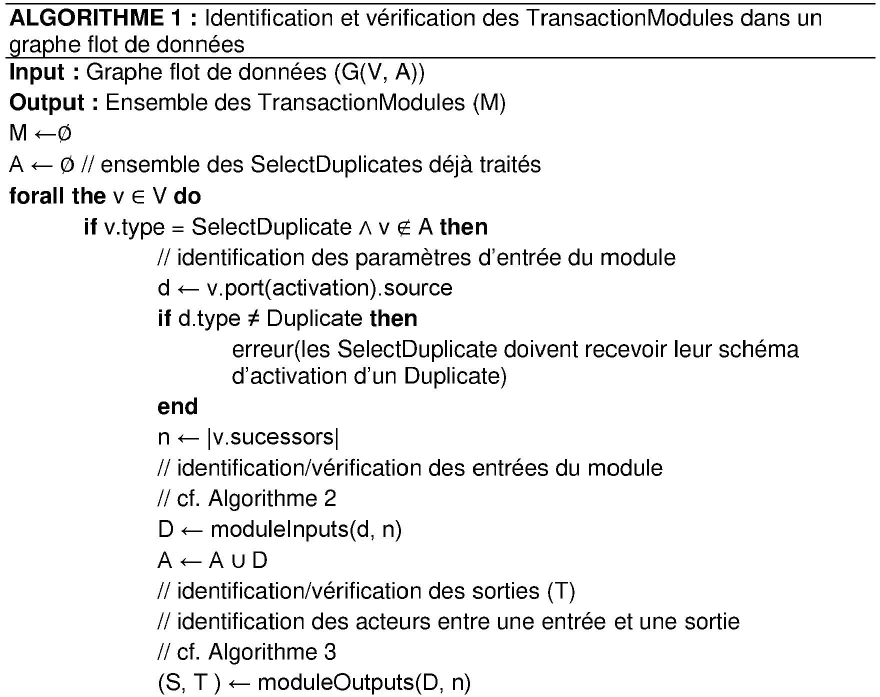

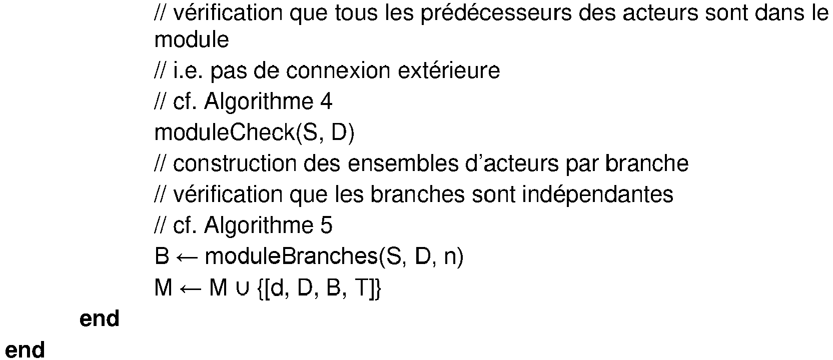

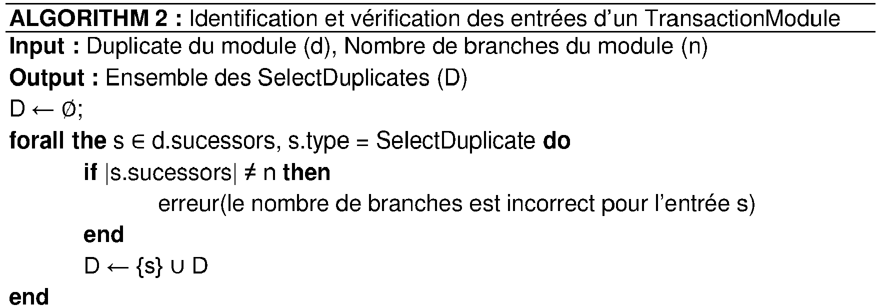

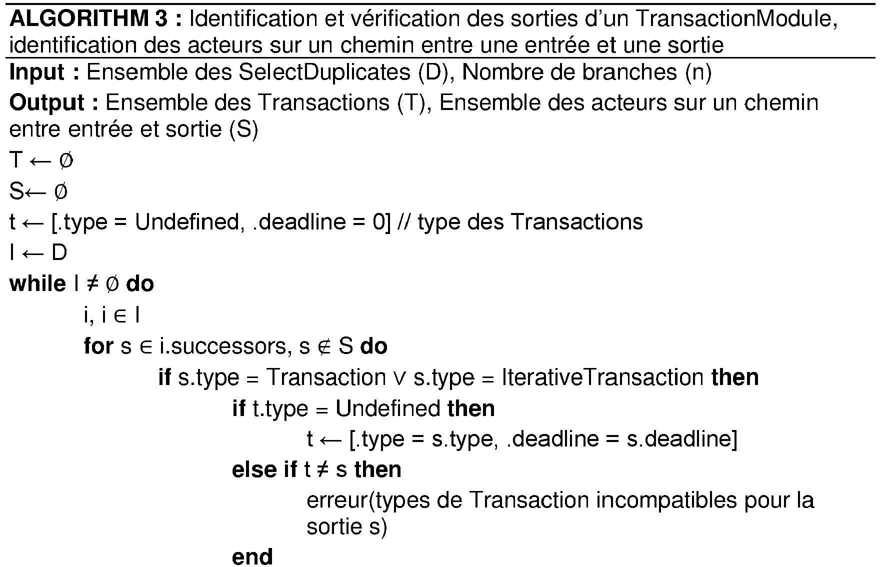

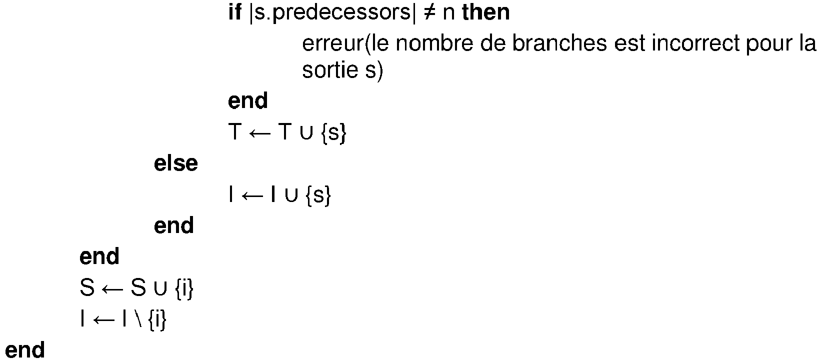

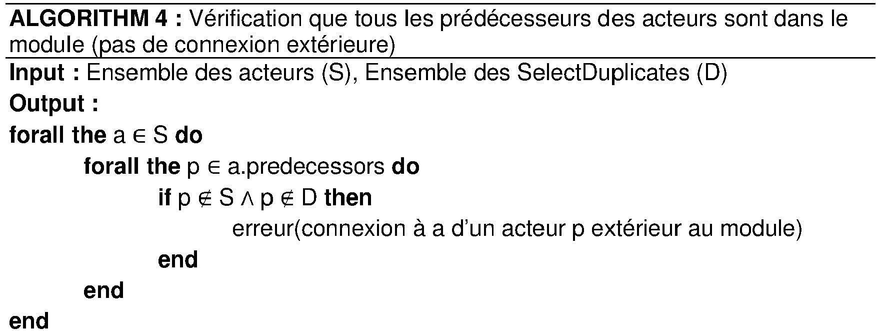

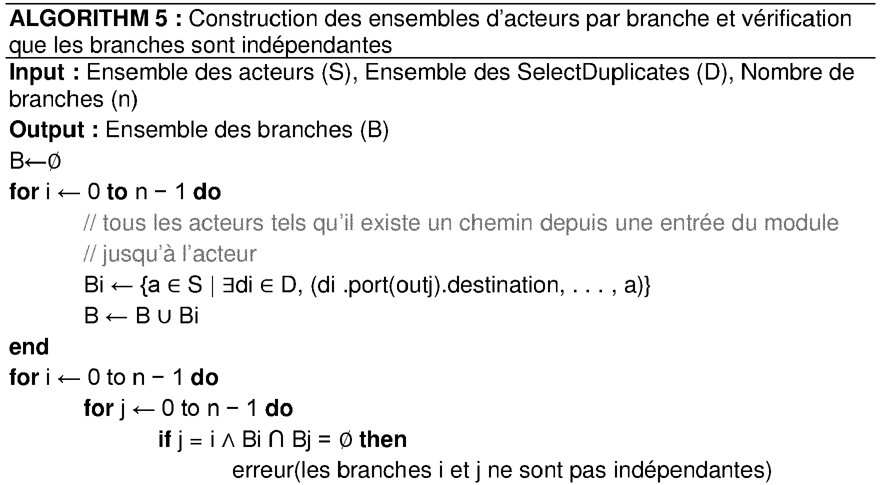

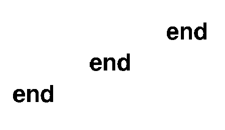

## Revendications

1. Procédé de compilation d'un graphe de flot de données, ledit procédé comprenant :
- Une étape de création d'au moins deux groupes d'instructions d'un code informatique correspondant à au moins deux premiers acteurs (310, 311) pour exécuter de manière indépendante le calcul d'un même ensemble de données comprenant au moins une donnée, et produire un descripteur de qualité de l'ensemble de données, l'exécution du calcul par chacun desdits au moins deux groupes d'instructions d'un code informatique étant déclenchée par un système de synchronisation ;
- Une étape de vérification qu'au moins un parmi les au moins deux groupes d'instructions d'un code informatique est capable d'exécuter son calcul de manière déterministe dans une durée prédéfinie (620);
- Une étape de création d'un troisième groupe d'instructions d'un code informatique correspondant à un troisième acteur (320), pour déclencher l'exécution du calcul par chacun desdits au moins deux groupes d'instructions d'un code informatique, et initialiser une horloge configurée pour émettre un signal d'interruption lorsque ladite durée prédéfinie est terminée ;
- Une étape de création d'un quatrième groupe d'instructions d'un code informatique correspondant à un quatrième acteur (330), pour exécuter, au plus tard au signal d'interruption de ladite horloge :
- La sélection, parmi l'ensemble desdits au moins deux groupes d'instructions d'un code informatique ayant produit un descripteur de qualité, de celui dont le descripteur présente la valeur la plus favorable ;
- Le transfert de l'ensemble de données calculé par le groupe d'instructions du code informatique sélectionné.

2. Procédé selon la revendication 1, comprenant préalablement à l'étape de création d'au moins deux groupes d'instructions d'un code informatique correspondant à au moins deux premiers acteurs :
- Une étape de vérification de l'existence des au moins deux premiers acteurs, du troisième acteur et du quatrième acteur ;
- Une étape de vérification que les canaux d'entrée des au moins deux premiers acteurs sont connectés au troisième acteur ;
- Une étape de vérification que les canaux de sortie des au moins deux premiers acteurs sont connectés au quatrième acteur ;
- Une étape de vérification que les canaux de sortie du troisième acteur sont connectés aux au moins deux premiers acteurs ;
- Une étape de vérification que les canaux d'entrée du quatrième acteur sont connectés aux au moins deux premiers acteurs.

3. Procédé selon l'une des revendications 1 et 2, dans lequel une erreur de compilation est générée lorsqu'aucun des au moins deux premiers groupes d'instructions d'un code informatique correspondant à au moins deux premiers acteurs (310, 311) n'est capable d'exécuter son calcul de manière déterministe dans une durée prédéfinie.

4. Système d'exécution comprenant des moyens adaptés pour exécuter un graphe de flot de données (300) compilé selon les étapes d'une des revendications précédentes, ledit graphe de flot de données (300) comprenant :
- Au moins deux premiers acteurs (310, 311), comprenant chacun des moyens pour exécuter de manière indépendante un calcul d'un même ensemble de données comprenant au moins une donnée, et produire un descripteur de qualité de l'ensemble de données, l'exécution du calcul par chacun desdits au moins deux premiers acteurs étant déclenchée par un système de synchronisation ;
- Un troisième acteur (320), comprenant des moyens pour déclencher l'exécution du calcul par chacun desdits au moins deux premiers acteurs, et initialiser une horloge configurée pour émettre un signal d'interruption lorsqu'une durée est écoulée ;
- Un quatrième acteur (330), comprenant des moyens pour exécuter, au plus tard au signal d'interruption de ladite horloge :
- La sélection, parmi l'ensemble desdits au moins deux premiers acteurs ayant produit un descripteur de qualité, de celui dont le descripteur présente la valeur la plus favorable ;
- Le transfert de l'ensemble de données calculé par l'acteur sélectionné.

5. Système d'exécution comprenant des moyens adaptés pour exécuter un graphe de flot de données selon la revendication 4, dans lequel au moins un desdits deux premiers acteurs (310, 311) est configuré pour s'exécuter de manière déterministe en un temps inférieur ou égal à la durée de l'horloge.

6. Système d'exécution comprenant des moyens adaptés pour exécuter un graphe de flot de données selon l'une des revendications 4 à 5, dans lequel le système de synchronisation de chacun desdits au moins deux premiers acteurs (310, 311) est un sémaphore, et le troisième acteur (320) déclenche l'exécution du calcul par chacun desdits au moins deux premiers acteurs (310, 311) par le don d'un jeton audit sémaphore.

7. Système d'exécution comprenant des moyens adaptés pour exécuter un graphe de flot de données selon l'une des revendications 4 à 6, dans lequel le troisième acteur (320) comprend des moyens pour transférer des données représentant des paramètres de calcul identiques (420b, 421b, 422b) à chacun desdits au moins deux premiers acteurs (310, 311), préalablement à l'initialisation de l'horloge.

8. Système d'exécution comprenant des moyens adaptés pour exécuter un graphe de flot de données selon la revendication 7, dans lequel chacun des au moins deux premiers acteurs (310, 311), produit un horodatage à la fin du transfert des données représentant des paramètres de calcul, et le troisième acteur (320) déclenche l'initialisation de l'horloge après réception des au moins deux horodatages.

9. Système d'exécution comprenant des moyens adaptés pour exécuter un graphe de flot de données selon l'une des revendications 4 à 8, dans lequel le troisième acteur (320) est configuré pour déclencher l'exécution d'un sous-ensemble uniquement des au moins deux premiers acteurs, en fonction d'un paramètre externe audit troisième acteur indiquant le sous-ensemble des au moins deux premiers acteurs à exécuter (411b).

10. Système d'exécution comprenant des moyens adaptés pour exécuter un graphe de flot de données selon la revendication 9, dans lequel le sous-ensemble des au moins deux premiers acteurs (311, 311) à exécuter comprend tous ceux pour lesquels les moyens de calcul adéquats sont disponibles.

11. Système d'exécution comprenant des moyens adaptés pour exécuter un graphe de flot de données selon l'une des revendications 4 à 10, dans lequel le quatrième acteur (340) comprend des moyens pour générer une erreur, lorsque, au signal d'interruption de l'horloge, le nombre parmi les au moins deux premiers acteurs (310, 311) ayant produit un descripteur de qualité est inférieur à un seuil prédéfini.

12. Système d'exécution comprenant des moyens adaptés pour exécuter un graphe de flot de données selon l'une des revendications 4 à 11, dans lequel le quatrième acteur est configuré pour sélectionner l'acteur dont le critère de qualité présente la valeur la plus favorable au signal d'interruption de l'horloge.

13. Système d'exécution comprenant des moyens adaptés pour exécuter un graphe de flot de données selon l'une des revendications 4 à 11, dans lequel le quatrième acteur est configuré pour sélectionner l'acteur dont le critère de qualité présente la valeur la plus favorable avant signal d'interruption de l'horloge, lorsqu'au moins un nombre prédéfini parmi les au moins deux premiers acteurs ont produit un descripteur de qualité.

14. Système d'exécution comprenant des moyens adaptés pour exécuter un graphe de flot de données selon l'une des revendications 4 à 13, dans lequel au moins un parmi les au moins deux premiers acteurs est configuré pour produire une mise à jour du calcul de son ensemble de données, ainsi que de son descripteur de qualité.

## Patentansprüche

1. Verfahren zum Kompilieren eines Datenflussgraphen, wobei das Verfahren Folgendes umfasst:
- einen Schritt des Erzeugens von mindestens zwei Befehlsgruppen eines Computercodes entsprechend mindestens zwei ersten Akteuren (310, 311), um unabhängig die Berechnung eines gleichen Datensatzes, der mindestens ein Datenelement umfasst, auszuführen und einen Qualitätsdeskriptor des Datensatzes zu produzieren, wobei die Ausführung der Berechnung durch jede der mindestens zwei Befehlsgruppen eines Computercodes durch ein Synchronisationssystem ausgelöst wird;
- einen Schritt des Verifizierens, dass mindestens eine der mindestens zwei Befehlsgruppen eines Computercodes ihre Berechnung auf deterministische Weise innerhalb einer vordefinierten Dauer ausführen kann (620);
- einen Schritt des Erzeugens einer dritten Befehlsgruppe eines Computercodes entsprechend einem dritten Akteur (320), um die Ausführung der Berechnung durch jede der mindestens zwei Befehlsgruppen eines Computercodes auszulösen und einen Zeitgeber zu initialisieren, der zum Senden eines Unterbrechungssignals konfiguriert ist, wenn die vordefinierte Dauer verstrichen ist;
- einen Schritt des Erzeugens einer vierten Befehlsgruppe eines Computercodes entsprechend einem vierten Akteur (330), um spätestens beim Unterbrechungssignal des Zeitgebers Folgendes auszuführen:
- Auswählen, aus dem Satz der mindestens zwei Befehlsgruppen eines Computercodes, der einen Qualitätsdeskriptor produziert hat, derjenigen, deren Deskriptor den günstigsten Wert aufweist;
- Übertragen des von der ausgewählten Befehlsgruppe des Computercodes berechneten Datensatzes.

2. Verfahren nach Anspruch 1, das vor dem Schritt des Erzeugens von mindestens zwei Befehlsgruppen eines Computercodes entsprechend mindestens zwei ersten Akteuren Folgendes umfasst:
- einen Schritt des Verifizierens der Existenz der mindestens zwei ersten Akteure, des dritten Akteurs und des vierten Akteurs;
- einen Schritt des Verifizierens, dass die Eingangskanäle der mindestens zwei ersten Akteure mit dem dritten Akteur verbunden sind;
- einen Schritt des Verifizierens, dass die Ausgangskanäle der mindestens zwei ersten Akteure mit dem vierten Akteur verbunden sind;
- einen Schritt des Verifizierens, dass die Ausgangskanäle des dritten Akteurs mit den mindestens zwei ersten Akteuren verbunden sind;
- einen Schritt des Verifizierens, dass die Eingangskanäle des vierten Akteurs mit den mindestens zwei ersten Akteuren verbunden sind.

3. Verfahren nach einem der Ansprüche 1 und 2, wobei ein Kompilierungsfehler erzeugt wird, wenn keine der mindestens zwei ersten Befehlsgruppen eines Computercodes entsprechend mindestens zwei ersten Akteuren (310, 311) ihre Berechnung auf deterministische Weise innerhalb einer vordefinierten Dauer ausführen kann.

4. Ausführungssystem, das Mittel umfasst, die zum Ausführen eines nach den Schritten eines der vorhergehenden Ansprüche kompilierten Datenflussgraphs (300) ausgelegt sind, wobei der Datenflussgraph (300) Folgendes umfasst:
- mindestens zwei erste Akteure (310, 311), die jeweils Mittel zum unabhängigen Ausführen einer Berechnung eines gleichen Datensatzes, der mindestens ein Datenelement umfasst, und zum Produzieren eines Qualitätsdeskriptors des Datensatzes umfasst, wobei die Ausführung der Berechnung durch jeden der mindestens zwei ersten Akteure durch ein Synchronisationssystem ausgelöst wird;
- einen dritten Akteur (320), der Mittel zum Auslösen der Ausführung der Berechnung durch jeden der mindestens zwei ersten Akteure und zum Initialisieren eines Zeitgebers umfasst, der zum Aussenden eines Unterbrechungssignals konfiguriert ist, wenn eine Dauer verstrichen ist;
- einen vierten Akteur (330), der Mittel umfasst, um spätestens beim Unterbrechungssignal des Zeitgebers Folgendes auszuführen:
- Auswählen, aus dem Satz der mindestens zwei ersten Akteure, die einen Qualitätsdeskriptor produziert haben, desjenigen, dessen Deskriptor den günstigsten Wert aufweist;
- Übertragen des von dem ausgewählten Akteur berechneten Datensatzes.

5. Ausführungssystem, das Mittel umfasst, die zum Ausführen eines Datenflussgraphen nach Anspruch 4 ausgelegt sind, wobei mindestens einer der beiden ersten Akteure (310, 311) zum Ausführen auf eine deterministische Weise in einer Zeit konfiguriert ist, die gleich oder kleiner als die Dauer des Zeitgebers ist.

6. Ausführungssystem, das Mittel umfasst, die zum Ausführen eines Datenflussgraphen nach einem der Ansprüche 4 bis 5 ausgelegt sind, wobei das Synchronisationssystem jedes der mindestens zwei ersten Akteure (310, 311) ein Semaphor ist und der dritte Akteur (320) die Ausführung der Berechnung durch jeden der mindestens zwei ersten Akteure (310, 311) durch die Gabe eines Tokens an den Semaphor auslöst.

7. Ausführungssystem, das Mittel umfasst, die zum Ausführen eines Datenflussgraphen nach einem der Ansprüche 4 bis 6 ausgelegt sind, wobei der dritte Akteur (320) Mittel zum Übertragen von Daten umfasst, die identische Rechenparameter (420b, 421b, 422b) zu jedem der mindestens zwei ersten Akteure (310, 311) repräsentieren, vor der Initialisierung des Zeitgebers.

8. Ausführungssystem, das Mittel umfasst, die zum Ausführen eines Datenflussgraphen nach Anspruch 7 ausgelegt sind, wobei jeder der mindestens zwei ersten Akteure (310, 311) am Ende der Übertragung von Daten, die Berechnungsparameter darstellen, einen Zeitstempel erzeugt, und der dritte Akteur (320) nach Empfang der mindestens zwei Zeitstempel die Initialisierung des Zeitgebers auslöst.

9. Ausführungssystem, das Mittel umfasst, die zum Ausführen eines Datenflussgraphen nach einem der Ansprüche 4 bis 8 ausgelegt sind, wobei der dritte Akteur (320) zum Auslösen der Ausführung nur einer Teilmenge der mindestens zwei ersten Akteure in Abhängigkeit von einem Parameter außerhalb des dritten Akteurs konfiguriert ist, der die Teilmenge der mindestens zwei ersten auszuführenden Akteure angibt (411b).

10. Ausführungssystem, das Mittel umfasst, die zum Ausführen eines Datenflussgraphen nach Anspruch 9 ausgelegt sind, wobei die Teilmenge der mindestens zwei ersten auszuführenden Akteure (311, 311) alle diejenigen umfasst, für die geeignete Rechenmittel zur Verfügung stehen.

11. Ausführungssystem, das Mittel umfasst, die zum Ausführen eines Datenflussgraphen nach einem der Ansprüche 4 bis 10 ausgelegt sind, wobei der vierte Akteur (340) Mittel zum Erzeugen eines Fehlers umfasst, wenn bei dem Unterbrechungssignal des Zeitgebers die Anzahl unter den mindestens zwei ersten Akteuren (310, 311), die einen Qualitätsdeskriptor produziert haben, unter einem vordefinierten Schwellenwert liegt.

12. Ausführungssystem, das Mittel umfasst, die zum Ausführen eines Datenflussgraphen nach einem der Ansprüche 4 bis 11 ausgelegt sind, wobei der vierte Akteur zum Auswählen des Akteurs konfiguriert ist, dessen Qualitätskriterium beim Unterbrechungssignal des Zeitgebers den günstigsten Wert aufweist.

13. Ausführungssystem, das Mittel umfasst, die zum Ausführen eines Datenflussgraphen nach einem der Ansprüche 4 bis 11 ausgelegt sind, wobei der vierte Akteur zum Auswählen des Akteurs konfiguriert ist, dessen Qualitätskriterium vor dem Unterbrechungssignal des Zeitgebers den günstigsten Wert aufweist, wenn mindestens eine vordefinierte Zahl unter den mindestens zwei ersten Akteuren einen Qualitätsdeskriptor erzeugt hat.

14. Ausführungssystem, das Mittel umfasst, die zum Ausführen eines Datenflussgraphen nach einem der Ansprüche 4 bis 13 ausgelegt sind, wobei mindestens einer der mindestens zwei ersten Akteure zum Erzeugen einer Aktualisierung der Berechnung seines Datensatzes und seines Qualitätsdeskriptors konfiguriert ist.

## Claims

1. A method for compiling a data flow graph, said method comprising:
- a step of creation of at least two groups of instructions of a computer code corresponding to at least two first actors (310, 311) for independently executing the computation of one and the same data set comprising at least one datum, and producing a quality descriptor of the data set, the execution of the computation by each of said at least two groups of instructions of a computer code being triggered by a synchronisation system;
- a step of verification that at least one out of the at least two groups of instructions of a computer code is capable of executing its computation deterministically within a predefined duration (620);
- a step of creation of a third group of instructions of a computer code corresponding to a third actor (320), for triggering the execution of the computation by each of said at least two groups of instructions of a computer code, and initialising a clock configured to emit an interrupt signal when said predefined duration is terminated;
- a step of creation of a fourth group of instructions of a computer code corresponding to a fourth actor (330), for executing, at the latest at the interrupt signal of said clock:
- the selection, from the set of said at least two groups of instructions of a computer code having produced a quality descriptor, of the one whose descriptor exhibits the most favourable value;
- the transfer of the data set computed by the selected group of instructions of the computer code.

2. The method according to claim 1, comprising, prior to the step of creation of at least two groups of instructions of a computer code corresponding to at least two first actors:
- a step of verification of the existence of the at least two first actors, of the third actor and of the fourth actor;
- a step of verification that the input channels of the at least two first actors are connected to the third actor;
- a step of verification that the output channels of the at least two first actors are connected to the fourth actor;
- a step of verification that the output channels of the third actor are connected to the at least two first actors;
- a step of verification that the input channels of the fourth actor are connected to the at least two first actors.

3. The method according to any one of claims 1 and 2, wherein a compilation error is generated when none of the at least two first groups of instructions of a computer code corresponding to at least two first actors (310, 311) is capable of executing its computation deterministically within a predefined duration.

4. An execution system comprising means adapted to execute a data flow graph (300), compiled according to steps of any one of the preceding claims, said data flow graph (300) comprising:
- at least two first actors (310, 311), each comprising means for independently executing a computation of one and the same data set comprising at least one datum, and producing a quality descriptor of the data set, the execution of the computation by each of said at least two first actors being triggered by a synchronisation system;
- a third actor (320), comprising means for triggering the execution of the computation by each of said at least two first actors, and initialising a clock configured to emit an interrupt signal when a duration has elapsed;
- a fourth actor (330), comprising means for executing, at the latest at the interrupt signal of said clock:
- the selection, from the set of said at least two first actors having produced a quality descriptor, of the one whose descriptor exhibits the most favourable value;
- the transfer of the data set computed by the selected actor.

5. An execution system comprising means adapted to execute a data flow graph according to claim 4, wherein at least one of said two first actors (310, 311) is configured to be executed deterministically in a time less than or equal to the duration of the clock.

6. An execution system comprising means adapted to execute a data flow graph according to any one of claims 4 to 5, wherein the synchronisation system of each of said at least two first actors (310, 311) is a semaphore, and the third actor (320) triggers the execution of the computation by each of said at least two first actors (310, 311) by giving a token to said semaphore.

7. An execution system comprising means adapted to execute a data flow graph according to any one of claims 4 to 6, wherein the third actor (320) comprises means for transferring data representing identical computation parameters (420b, 421b, 422b) to each of said at least two first actors (310, 311), prior to the initialisation of the clock.

8. An execution system comprising means adapted to execute a data flow graph according to claim 7, wherein each of the at least two first actors (310, 311), produces a timestamp at the end of the transfer of the data representing computation parameters, and the third actor (320) triggers the initialisation of the clock after the reception of the at least two timestamps.

9. An execution system comprising means adapted to execute a data flow graph according to any one of claims 4 to 8, wherein the third actor (320) is configured to trigger the execution of a subset only of the at least two first actors, as a function of a parameter external to said third actor indicating the subset of the at least two first actors to be executed (411b).

10. An execution system comprising means adapted to execute a data flow graph according to claim 9, wherein the subset of the at least two first actors (311, 311) to be executed comprises all those for which the appropriate computation means are available.

11. An execution system comprising means adapted to execute a data flow graph according to any one of claims 4 to 10, wherein the fourth actor (340) comprises means for generating an error, when, at the interrupt signal of the clock, the number out of the at least two first actors (310, 311) having produced a quality descriptor is below a predefined threshold.

12. An execution system comprising means adapted to execute a data flow graph according to any one of claims 4 to 11, wherein the fourth actor is configured to select the actor whose quality criterion exhibits the most favourable value at the interrupt signal of the clock.

13. An execution system comprising means adapted to execute a data flow graph according to any one of claims 4 to 11, wherein the fourth actor is configured to select the actor whose quality criterion exhibits the most favourable value before the interrupt signal of the clock, when at least a predefined number out of the at least two first actors have produced a quality descriptor.

14. An execution system comprising means adapted to execute a data flow graph according to any one of claims 4 to 13, wherein at least one out of the at least two first actors is configured to produce an update of the computation of its data set, and of its quality descriptor.
